# EUROPEAN PATENT APPLICATION

(11) **EP 2 261 768 A2**
(43) Date of publication of application: **15.12.2010**
(21) Application number: 10163001.0
(22) Date of filing: 17.05.2010
(51) Int. Cl.: G06F 1/20

(54) **Fan control apparatus and fan control method**

(30) Priority: 21.05.2009 JP 2009123500
(71) Applicant: Fujitsu Limited, Kawasaki-shi, Kanagawa 211-8588 (JP)
(72) Inventor: Nitta, Kazuhiro, Kanagawa 211-8588 (JP); Yamaguchi, Atsushi, Kawasaki-shi, Kanagawa 211-8588 (JP); Furuya, Hiroyuki, Kawasaki-shi, Kanagawa 211-8588 (JP)
(74) Representative: Stebbing, Timothy Charles

(57) **Abstract**

A fan controlling apparatus (1) for controlling a plurality of fans (3a, 3b) used to control a temperature of a heat generating object in electronic apparatus such as a PC or server. The apparatus includes a memory for storing data of the rotational speed each of the fans (3a, 3b) in relation to the temperature of the heat generating object, and a controller for controlling the rotational speed of each of the fans respectively in dependence on the temperature of the heat generating object in reference to the data stored in the memory. The respective fan speeds are maintained within a predetermined tolerance so as to minimise the overall noise level.

## Description

The present invention relates to a fan control apparatus and a fan control method.

In existing electronic equipment such as a server device, a PC (Personal Computer) and others, fans are often employed to induce a cooling flow of air, in order to avoid temperature rising in the equipment with heat generated from a processor or the like are mounted in the equipment.

In a fan, noise (whirring sounds) is generated owing to formation of air eddies in the vicinity of blades. Noise generated from a fan is increased with increasing an air flow rate at which the fan operates. Therefore, if it is intended to increase the spin speed or in other words number of revolutions (hereinafter, referred to as the revolution number) of the fan to increase the air flow rate, the noise will be increased accordingly. Specifically, it is known that noise from a fan is proportional to the fifth or sixth power of the spin speed (number of axial rotations per unit time) of the fan.

Recently, such a situation has been more and more frequently observed that electronic equipment is installed not only in a specific place such as a computer room but also in a home or office and hence consciousness of noise reduction is now being raised. Therefore, reducing the noise generated from a fan is an important problem to be solved.

A known method of reducing fan noise is that of monitoring the temperature of a heating element (target of cooling, such as a processor) and the environmental temperature around the heating element and changing the revolution number of the fan concerned in accordance with the temperatures so monitored to keep fan noise to a minimum. The revolution number of the fan is controlled by modulating the pulse width (the PWM value) of a voltage or PWM (Pulse Width Modulation) signal to control energy to be supplied to the motor of the fan.

On the hand, nowadays, in some cases, a space for an air passage in equipment is reduced with size and thickness reduction of the electronic equipment and such a case in which only a small fan is allowed to be installed is now being more frequently observed. In addition, a heating value of electronic equipment tends to increase as processing speed and performance of electronic equipment get higher. Thus, such a countermeasure is taken that a plurality of fans is superposed on one another in a multi-stage form, e.g. placed in series. so as to sufficiently cool the inside of electronic equipment even when installation of only small-sized fans is allowed.

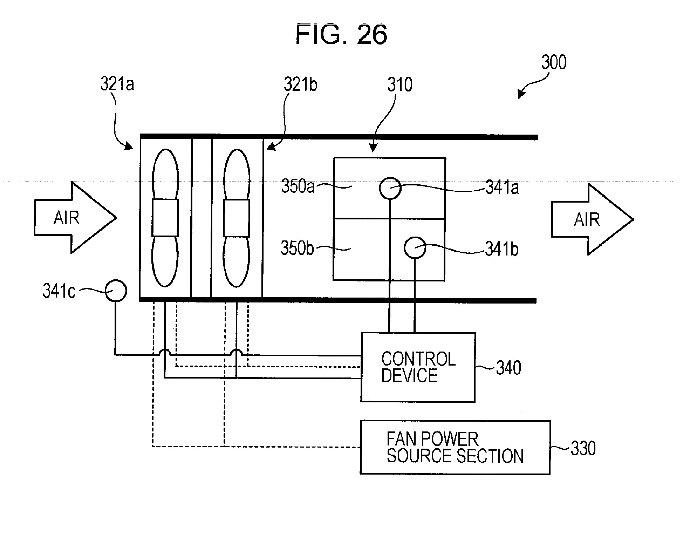

In this connection, an example in which a plurality of fans is superposed on one another in a multi-stage form is illustrated in FIG. 26. FIG. 26 illustrates an example of electronic equipment in which two fans are disposed in series.

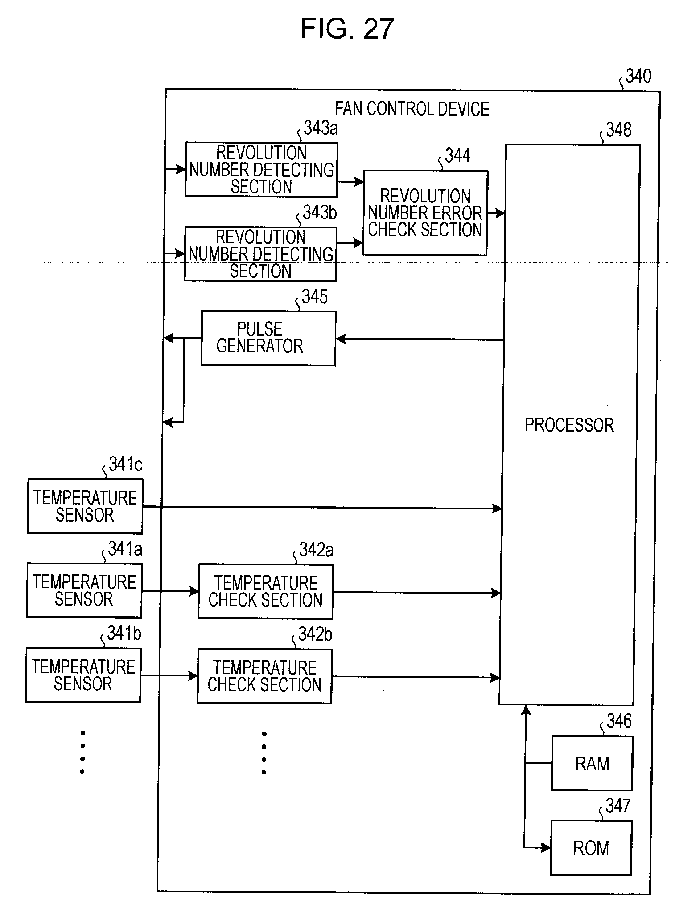

As illustrated in FIG. 26, two fans 321a and 321b are installed in series in an air passage 310 of electronic equipment 300. The electronic equipment 300 includes a fan power source section 330 and a control section 340. The fan power source section 330 is a power source for supplying power to motors (not illustrated) which are built in the fans 321a and 321b. The control section 340 controls amounts of energy supplied to the fans 321a and 321b on the basis of temperatures of heating elements 350a and 350b detected using temperature sensors 341a and 341b and an environmental temperature detected using a temperature sensor 341c. Next, a specific configuration of the control section 340 will be illustrated. FIG. 27 is a block diagram illustrating a configuration of the existing control section 340.

As illustrated in FIG. 27, the control section 340 includes the temperature sensors 341a to 341c, temperature check sections 342a and 342b, revolution number detecting sections 343a and 343b, a revolution number error check section 344 and a pulse generator 345. The control section 340 also includes a RAM (Random Access Memory) 346, a ROM (Read Only Memory) 347 and a processor 348.

The temperature sensors 341a and 341b are attached to the heating elements 350a and 350b in the electronic equipment 300 to detect the temperatures of the heating elements 350a and 350b. The temperature sensor 341c is installed outside of the electronic equipment 300 to detect the environmental temperature around the fan 321a. The temperature check sections 342a and 342b check to see to which extent the temperatures of the heating elements 350a and 350b detected using the temperature sensors 341a and 341b vary from a target temperature and notify the processor 348 of results of check in the form of predetermined variables.

The revolution number detecting sections 343a and 343b detect the revolution numbers (spin speeds) of the fans 321a and 321b. The revolution number check section 344 checks to see whether the fans 321a and 321b normally rotate on the basis of the revolution numbers of the fans 321 a and 321b detected using the revolution number detecting sections 343a and 343b and notifies the processor 348 of a result of this check. The pulse generator 345 inputs pulses for controlling the revolution numbers of the fans 321a and 321b into the fans 321a and 321b in pulse widths in accordance with an instruction from the processor 348.

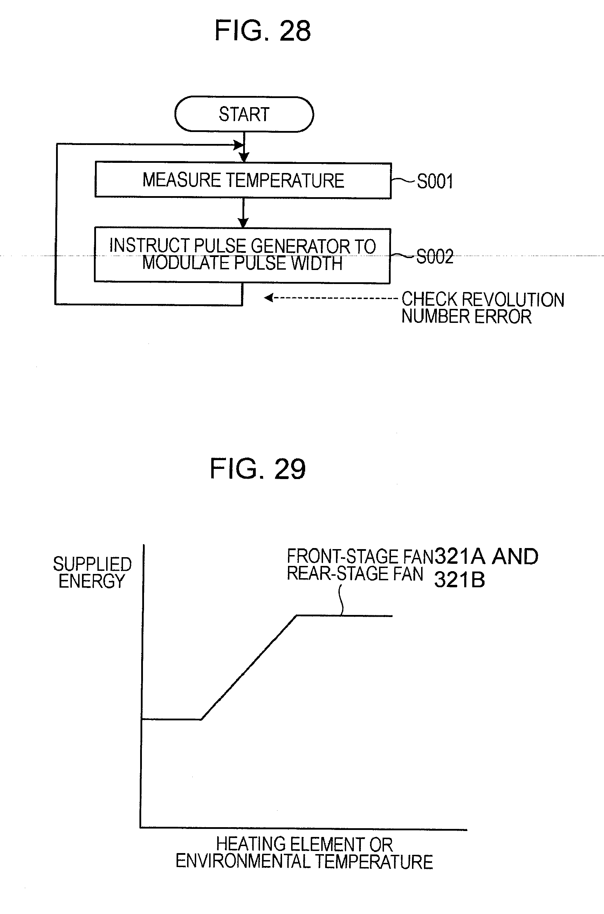

The ROM 347 stores therein a table indicating predetermined variables corresponding to temperatures of the heating elements 350a and 350b and PWM values of pulses to be input into the heating elements 350a and 350b in one-to-one correspondence and a table indicating environmental temperatures and the PWM values in one-to-one correspondence. The processor 348 determines the pulse widths of pulses to be output to the fans 321a and 321b on the basis of the predetermined variables sent from the temperature check sections 342a and 342b and the environmental temperature detected using the temperature sensor 341c. A specific example thereof is as illustrated in FIG. 27. FIG. 28 is a flowchart illustrating an example of procedures of processing executed using the existing processor 348.

As illustrated in FIG. 28, first, the processor 348 performs temperature measurement (step S001). That is, the processor 348 acquires predetermined variables corresponding to the temperatures of the heating elements 350a and 350b detected using the temperature sensors 341a and 341b from the temperature check sections 342a and 342b. The processor 348 also acquires the environmental temperature detected using the temperature sensor 341 c.

Next, the processor 348 instructs the pulse generator 345 to modulate the pulse widths on the basis of results of measurement of the environmental temperature and the temperatures of the heating elements 350a and 350b (step S002). Specifically, first, the processor 348 determines PWM values corresponding to the predetermined variables acquired from the temperature check sections 342a and 342b or the environmental temperature acquired from the temperature sensor 341c on the basis of the tables stored in the ROM 347. Then, the processor 348 instructs the pulse generator 345 to modulate widths of pulses to be input into the fans 321a a and 321b to have the PWM values so determined (step S002).

The pulse generator 345 then inputs pulses whose widths have been modulated to have the PWM values as instructed from the processor 348. As a result, the revolution numbers of the fans 321a and 321b are changed to the revolution numbers conforming to the environmental temperature and the temperatures of the heating elements 350a and 350b. As described above, the existing processor 348 determines the pulse widths on the basis of the environmental temperature and the temperatures of the heating elements 350a and 350b. Incidentally, the existing control section 340 detects the revolution numbers of the fans 321a and 321b using the revolution number detecting sections 343a and 343b to check on errors in the revolution numbers. Specifically, the processor 348 sends an error notification that the fans 321a and 321b are now in stopped states to the electronic equipment 300 on the basis of results of revolution number error check acquired from the revolution number error check section 344.

Incidentally, hitherto, the control section 340 has controlled the fans 321a and 321b in the same manner. In the following, the fan 321a which is situated on the side of taking air into the equipment from the outside will be referred to as a front-stage fan 321a and the fan 321b which is situated on the side of sending the air into the electronic equipment 300 will be referred to as a rear-stage fan 321b.

The processor 348 determines a pulse width of a pulse which is commonly input into the front-stage fan 321a and the rear-stage fan 321b at step S002 in FIG. 28 and notifies the pulse generator 345 of the pulse width. As a result, hitherto, energy of the same amount has been usually supplied from the pulse generator 345 to the front- stage fan 321a and the rear-stage fan 321b as illustrated in FIG. 29.

However, in the case that the fans 321a and 321b are superposed on each other in a multi-stage form, the work amount with which the rear-stage fan 321b blows off air is reduced influenced by an air current generated from the front-stage fan 321a. Therefore, if the amount of energy supplied to the front-stage fan 321a is the same as that supplied to the rear-stage fan 321b, the rear-stage fan 321b will run idle and hence the revolution number of the rear-stage fan 321b will be increased. Noise is generated greatly influenced by the operation of the fan of the largest revolution number and hence an increase in revolution number of the rear-stage fan 321b will be a major factor to cause an increase in noise.

In this connection, a technique for, example, making the revolution number of the front-stage fan 321a different from that of the rear-stage fan 321b is known. Specifically, in the above mentioned technique, the pulse width of a pulse input into the rear-stage fan 321b is controlled to become shorter than that of a pulse input into the front-stage fan 321a. In the above mentioned case, if the revolution number of the rear-stage fan 321 b is reduced, an air flow rate (needed air flow rate) needed to cool heating elements may not be possibly obtained. Therefore, it may become needed to increase the revolution number of the front-stage fan 321a more than that needed when the energy of the same amount is applied to each of the fans 321a and 321b. An example of the above mentioned technique is disclosed, for example, in Japanese Laid-open Patent Publication No. 2004-179186.

However, in the above mentioned known technique, the revolution number of the front-stage fan 321a is simply increased with no consideration of the system impedance characteristic of the electronic equipment 300, so that the noise may be rather increased as compared with a case in which the energy of the same amount is applied to each of the fans 321a and 321b. The system impedance characteristic is a pressure loss determined from a density at which components constituting the electronic equipment 300 are packaged and the shape of an air passage therein and is a characteristic intrinsic to the electronic equipment 300 concerned.

That is, the noise generated from the fans 321a and 321b varies depending on the characteristics and the shapes of these fans 321a and 321b and also depending on the configuration of the electronic equipment 300 concerned on which the fans 321a and 321b are mounted and locations of the fans 321a and 321b in the electronic equipment 300 concerned. Therefore, if the revolution number of the front-stage fan 321 is simply increased, the noise generated from the front-stage fan 321a may be possibly increased more than the noise generated from the rear-stage fan 321b when the energy of the same amount is applied to each of the fans 321 a and 321b depending on the locations of the fans.

Accordingly, it is desirable to decrease noise generated from a plurality of fans in the case that the plurality of fans are used to attain an air flow rate needed to cool heating elements within electronic apparatus such as a server or PC.

According to an aspect of the embodiments, there is provided a fan controlling apparatus for controlling a plurality of fans used to control a temperature of a heat generating object, the apparatus including a memory for storing data of the rotational speed each of fans in relation to the temperature of the heat generating object, and, a controller for controlling the rotational speed of each of the fans respectively in dependence on the temperature of the heat generating object in reference to the data stored in the memory. The plurality of fans may be arranged in series, e.g. in tandem in the case of two fans, within an air cooling chamber of apparatus including the heat generating object, and to which the heat generating object is exposed, e.g. by being placed within the chamber.

Reference is made, by way of example only, to the accompanying drawings in which:

FIG. 1 is a block diagram illustrating a configuration of a fan control device according to an embodiment 1;

FIG. 2 is a diagram illustrating a configuration of electronic equipment according to an embodiment 2;

FIG. 3 is a block diagram illustrating a configuration of a fan control device according to the embodiment 2;

FIG. 4 is a block diagram illustrating specific configurations of a processor and a ROM according to the embodiment 2;

FIG. 5 is a diagram illustrating an example of an equipment state management table;

FIG. 6 is a diagram illustrating information stored in a control data storage section according to the embodiment 2;

FIG. 7A is a diagram illustrating an example of a heating-element- temperature-based PWM value determination table;

FIG. 7B is a diagram illustrating an example of an environmental-temperature-based PWM value determination table;

FIG. 8 is a diagram explaining a difference between energy supplied to a front-stage fan and energy supplied to a rear-stage fan;

FIG. 9 is a diagram illustrating a specific configuration of a database preparing section according to the embodiment 2;

FIG. 10 is a flowchart illustrating an example of procedures of preparing the heating-element-temperature-based PWM value determination table and the environmental-temperature-based PWM value determination table;

FIG. 11 is a flowchart illustrating an example of procedures of processing executed using the processor according to the embodiment 2;

FIG. 12 is a diagram illustrating effects brought about by the embodiment 2;

FIG. 13 is a diagram illustrating examples of measurement conditions involving experiments for validation;

FIG. 14A is a diagram illustrating data indicative of a result of measurement of the front-stage revolution number, the rear-stage revolution number and the device noise performed under a measurement condition A;

FIG. 14B is a diagram illustrating data indicative of a result of measurement of the front-stage revolution number, the rear-stage revolution number and the consumption power performed under the measurement condition A;

FIG. 14C is a diagram illustrating data indicative of a result of analysis of frequencies of the device noise performed under the measurement condition A;

FIG. 15A is a diagram illustrating a result of measurement performed under a condition A-1;

FIG. 15B is a diagram illustrating a result of measurement performed under a condition A-2;

FIG. 15C is a diagram illustrating a result of measurement performed under a condition A-3;

FIG. 16A is a diagram illustrating data indicative of a result of measurement of the front-stage average revolution number, the rear-stage average revolution number and the device noise performed under conditions B-1 and B-2;

FIG. 16B is a diagram illustrating data indicative of a result of measurement of the front-stage average revolution number, the rear-stage average revolution number and the consumption power performed under the conditions B-1 and B-2;

FIG. 16C is a diagram illustrating data indicative of a result of analysis of frequencies of the device noise performed under the conditions B1 and B2;

FIG. 17A is a diagram illustrating a result of measurement performed under the condition B-1;

FIG. 17B is a diagram illustrating a result of measurement performed under the condition B-2;

FIG. 18A is a diagram illustrating data indicative of a result of measurement of the front-stage average revolution number, the rear-stage average revolution number and the device noise performed under conditions B-3 and B-4;

FIG. 18B is a diagram illustrating data indicative of a result of measurement of the front-stage average revolution number, the rear-stage average revolution number and the consumption power performed under the conditions B-3 and B-4;

FIG. 18C is a diagram illustrating data indicative of a result of analysis of frequencies of the device noise performed under the conditions B3 and B4;

FIG. 19A is a diagram illustrating a result of measurement performed under the condition B-3;

FIG. 19B is a diagram illustrating a result of measurement performed under the condition B-4;

FIG. 20 is a functional block diagram illustrating an example of a computer for executing a fan control program;

FIG. 21 is a block diagram illustrating a configuration of a fan control device according to an embodiment 3;

FIG. 22 is a block diagram illustrating specific configurations of a processor and a ROM according to the embodiment 3;

FIG. 23 is a diagram illustrating information stored in a control data storage section according to the embodiment 3;

FIG. 24 is a diagram illustrating an example of a rear-stage PWN value change table;

FIG. 25 is a flowchart illustrating an example of procedures of processing executed using the processor according to the embodiment 3;

FIG. 26 is a diagram illustrating an example of electronic equipment in which two fans are disposed in series;

FIG. 27 is a block diagram illustrating a configuration of an existing control section;

FIG. 28 is a flowchart illustrating an example of procedures of processing executed using an existing processor; and

FIG. 29 is a diagram illustrating that the amount of energy supplied to a front-stage fan is the same as that supplied to a rear-stage fan.

Next, preferred embodiments of a fan control device, a fan control method and a fan control program disclosed in the present application will be described in detail with reference to the accompanying drawings.

### [Embodiment 1]

A fan control device according to an embodiment 1 will be described. The fan control device according to the embodiment 1 is a control device that controls operational conditions of a plurality of fans disposed in series relative to an air passage formed in equipment, for example two fans in tandem.

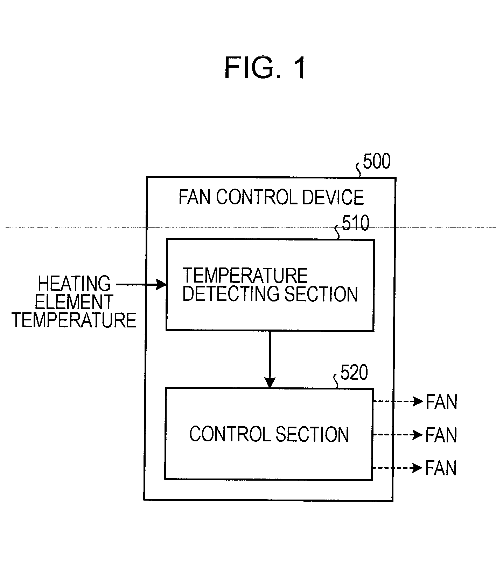

The plurality of fans cause a flow of air past one or more cooling targets, henceforth referred to as heating elements, disposed in the equipment to forcibly air-cool the heating elements. The fan control device controls the spin speed, henceforth called revolution number of each of the plurality of fans. By "revolution number" is implied a number of rotations of the fan blades per unit time, as in min⁻¹ (revolutions per minute) for example. The air passage in which the fans are disposed is referred to as a "pipeline" having a certain air resistance or "pipeline resistance". FIG. 1 is a block diagram illustrating a configuration of the fan control device according to the embodiment 1.

As illustrated in FIG. 1, a fan control device 500 according to the embodiment 1 includes a temperature detecting section 510 and a control section 520. The temperature detecting section 510 detects the temperature of each heating element. The control section 520 then controls the revolution numbers of the fans such that an air flow rate needed for cooling the heating elements is obtained in a state that the revolution numbers of the fans coincide with each other on the basis of the temperatures of the heating elements detected using the temperature detecting section 510.

Specifically, the control section 520 according to the embodiment 1 controls the revolution numbers of the fans such that the needed air flow rate (the cooling air flow rate) needed to cool the heating elements obtained from the temperatures of the heating elements, the pipeline resistance in the equipment and the total static pressure-air flow rate characteristic of the fans in a state in which a difference in revolution number between the fans is in a predetermined tolerance is acquired, and the difference in revolution number between the fans is set in the predetermined tolerance. By controlling the revolution number of each fan in the above mentioned manner, the respective fans run at similar speeds within the predetermined tolerance, that is, rotate in a state in which the revolution numbers of the respective fans coincide with each other in the predetermined tolerance, to send air to the heating elements at a needed air flow rate determined in accordance with the current temperature of each heating element.

As described above, the fan control device 500 according to the embodiment 1 controls so as to maintain the difference in revolution number between the fans in the predetermined tolerance, desirably, so as to control the revolution numbers of the fans to coincide with each other. Therefore, such a situation may be avoided that the total noise generated from the fans is increased owing to excess noise from driving one fan faster.

The needed air flow rate attained according to the embodiment 1 is obtained by taking the temperatures of the heating elements, the pipeline resistance in the equipment and the total static pressure-air flow rate characteristic of the fans obtained in a state in which the difference in revolution number between the fans is maintained in the predetermined tolerance into consideration. Therefore, according to the embodiment 1, the air flow rate suited to cool the heating elements may be obtained whilst matching the fan speeds within the predetermined tolerance regardless of the configuration of the equipment and the locations of the fans in the equipment.

Therefore, according to the embodiment 1, it may be possible to reduce the noise generated from the plurality of fans while obtaining the air flow rate needed for cooling the heating elements in the equipment using the plurality of fans.

### [Embodiment 2]

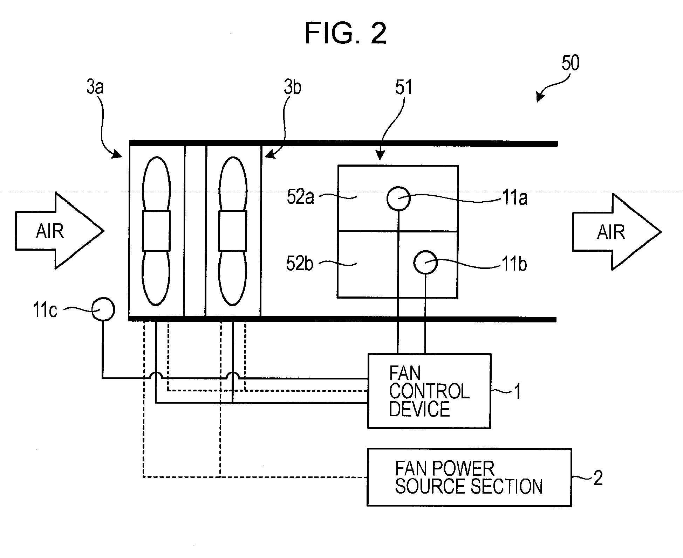

Next, a fan control device according to an embodiment 2 will be described. The fan control device according to the embodiment 2 is configured to control two fans installed in electronic equipment such as a rack-mounted type server device, a general PC and the like. First, a configuration of electronic equipment in which the fan control device according to the embodiment 2 is installed will be described. FIG. 2 is a diagram illustrating a configuration of the electronic equipment according to the embodiment 2.

As illustrated in FIG. 2, electronic equipment 50 according to the embodiment 2 includes two fans 3a, 3b and heating elements 52a and 52b such as processors installed in or otherwise exposed to an air passage 51 formed in the electronic equipment 50.

The fans 3a and 3b are axial fans of the same shape and characteristic. The fans 3a and 3b are disposed in series relative to the air passage 51 and generate air currents flowing from the fan 3a toward the fan 3b to forcibly air-cool the heating elements 52a and 52b disposed downstream of the air currents. In the following, of the fans 3a and 3b, the fan 3a for sucking air from the outside of the electronic equipment 50 will be referred to as a front-stage fan, and the fan 3b for distributing the air which has been drawn in using the front-stage fan 3a into the electronic equipment 50 will be referred to as a rear-stage fan.

The electronic equipment 50 also includes a fan control device 1 and a fan power source section 2 installed outside of the air passage 51. The fan power source section 2 is a power source for supplying power to motors (not shown) built into the fans 3a and 3b. That is, when the power is supplied from the fan power source section 2, the motors of the fans 3a and 3b rotate and blades attached to the motors rotate in cooperation with the rotation of the motors, and hence the fans 3a and 3b generate air currents flowing toward the heating elements 52a and 52b.

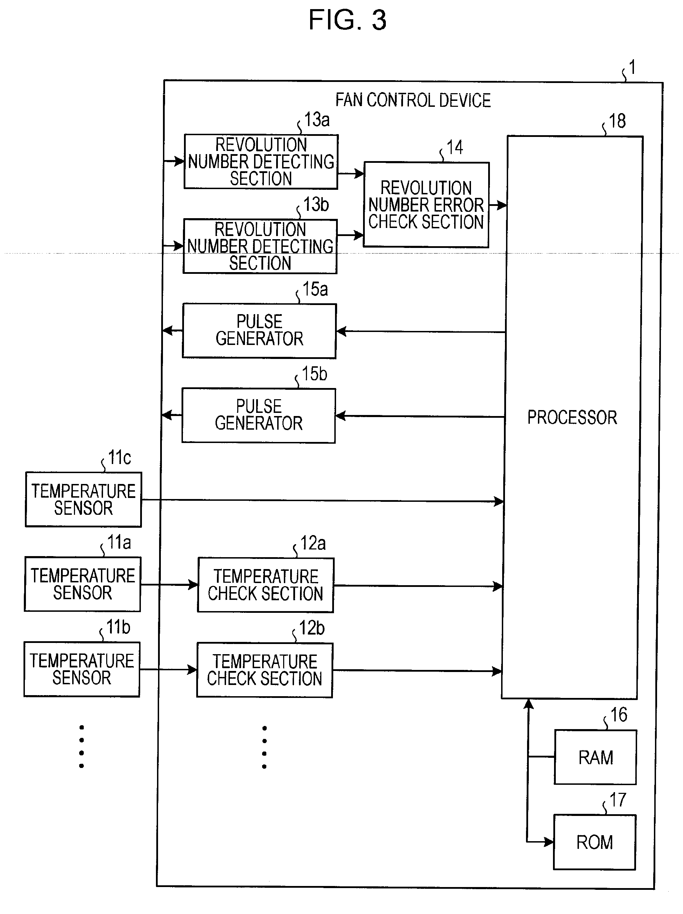

The fan control device 1 detects the temperatures of the heating elements 52a and 52b and the temperature (the environmental temperature) outside of the electronic equipment 50 using temperature sensors 11a to 11c. The fan control device 1 then controls the speeds of the fans 3a and 3b so as to obtain an air flow rate needed for cooling the heating elements 52a and 52b in a state in which the speed difference between the fans 3a and 3b is maintained in the predetermined tolerance on the basis of the temperatures detected using the temperature sensors 11a to 11c. Next, a specific configuration of the fan control device 1 described above will be illustrated. FIG. 3 is a block diagram illustrating a configuration of the fan control device according to the embodiment 2.

As illustrated in FIG. 3, the fan control device 1 includes the temperature sensors 11a to 11c, temperature check sections 12a and 12b, revolution number detecting sections 13a and 13b, a revolution number error check section 14 and pulse generators 15a and 15b. The fan control device 1 also includes a RAM 16, a ROM 17 and a processor 18.

The temperature sensors 11a and 11b are attached to the heating elements 52a and 52b and detect the temperatures of the heating elements 52a and 52b. The temperature sensor 11C is disposed outside of the electronic equipment 50 and detects the environmental temperature around the front-stage fan 3a. The temperature sensors 12a and 12b check to see to which extent the temperatures of the heating elements 52a and 52b detected using the temperature sensors 11a and 11b are varied from a target temperature and notify the processor 18 of results of check in the form of predetermined variables.

The revolution number detecting sections 13a and 13b are, for example, pulse counters and respectively detect the revolution numbers of the fans 3a and 3b. The revolution number error check section 14 checks to see whether the fans 3a and 3b normally rotate on the basis of the revolution numbers of the fans 3a and 3b detected using the revolution number detecting sections 13a and 13b and notifies the processor 18 of a result of this check.

The pulse generators 15a and 15b input pulses used to control the revolution numbers of the fans 3a and 3b in pulse widths (PWM values) as instructed from the processor 18 into the fans 3a and 3b. Specifically, the pulse generator 15a inputs a pulse of a PWM value as instructed from the processor 18 into the front-stage fan 3a. The pulse generator 15b inputs a pulse of a PWM value as instructed from the processor 18 into the rear-stage fan 3b. As a result, the fans 3a and 3b rotate with the revolution numbers conforming to the pulse widths of the pulses input from the pulse generators 15a and 15b.

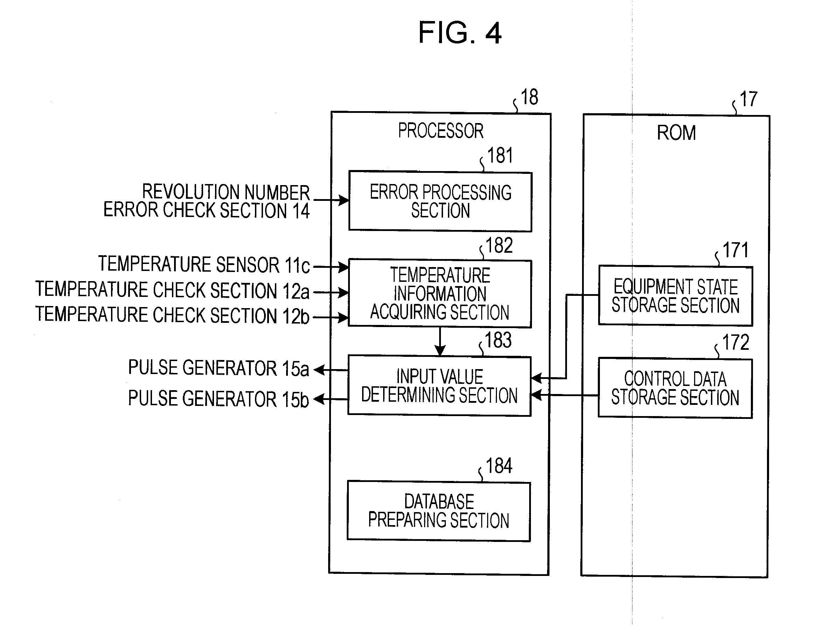

The ROM 17 stores therein various pieces of data needed for processing executed using the processor 18. The processor 18 determines PWM values of pulses to be input into the front-stage fan 3a and the rear-stage fan 3b on the basis of the temperatures detected using the temperature sensors 11a to 11c. Next, specific configurations of the processor 18 and the ROM 17 according to the embodiment 2 will be described. FIG. 4 is a block diagram illustrating the specific configurations of the processor 18 and the ROM 17 according to the embodiment 2.

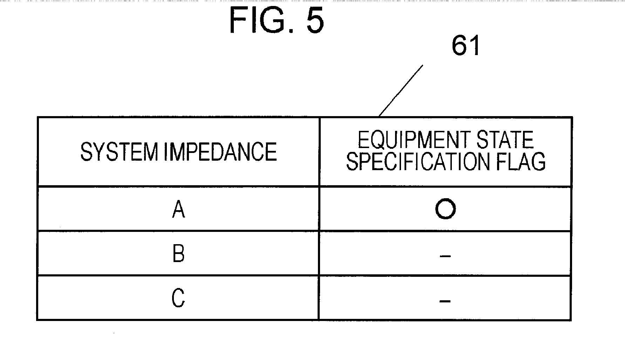

As illustrated in FIG. 4, the ROM 17 includes an equipment state storage section 171 and a control data storage section 172. The equipment state storage section 171 stores an equipment state management table. The equipment state management table is a table used to specify the system impedance (the pipeline resistance) corresponding to the current configuration of the electronic equipment 50. FIG. 5 illustrates an example of the equipment state management table 61.

As illustrated in FIG. 5, in equipment state management table 61, system impedances and one equipment state specification flag are stored such that the flag corresponds to one of the impedances. In the example illustrated in the drawing, the impedance is a pressure loss determined from a density rate at which the respective components of the electronic equipment 50 are packaged and the shape of an air passage in the equipment. In the equipment state management table 61 according to the embodiment 2, a plurality of impedances measured by changing the configuration of the electronic equipment 50 are stored and the equipment state specification flag is set for a system impedance corresponding to the current configuration of the electronic equipment 50.

For example, in the equipment state management table 61 illustrated in FIG. 5, system impedances A to C respectively measured by changing the configuration of the electronic equipment 50 are stored and the electronic state specification flag is set for the system impedance A. That is, the equipment state management table 61 illustrated in FIG. 5 indicates that the system impedance corresponding to the current configuration of the electronic equipment 50 is "A". In the case that the configuration of the electronic equipment has been changed, the equipment state management table 61 is manually updated by a user of the electronic equipment 50. Owing to the above mentioned operation, even when the configuration of the electronic equipment 50 has been changed, the system impedance corresponding to a fresh configuration of the electronic equipment 50 may be specified.

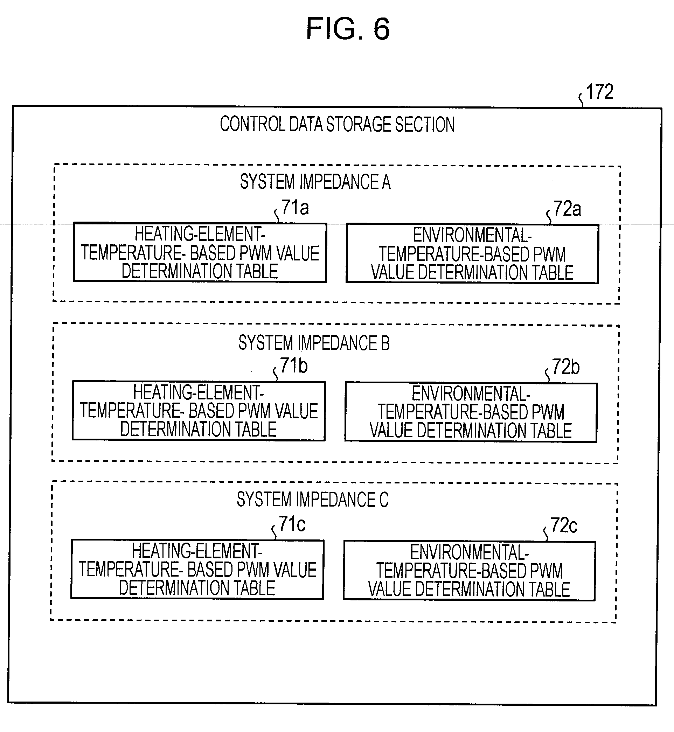

The control data storage section 172 stores a heating-element-temperature-based PWM value determination table and an environmental-temperature-based PWM value determination table. The heating-element-temperature-based PWM value determination table is a table used to specify PWM values of pulses to be input into the fans 3a and 3b on the basis of the temperatures of the heating elements 52a and 52b. The environmental-temperature-based PWM value determination table is a table used to specify PWM values of pulses to be input into the fans 3a and 3b on the basis of the environmental temperature. Next, these pieces of information stored in the control data storage section 172 will be specifically described. FIG. 6 is a diagram for explaining information stored in the control data storage section 172 according to the embodiment 2.

As illustrated in FIG. 6, the control data storage section 172 stores heating-element-temperature-based PWM value determination tables 71a to 71c and environmental-temperature-based PWM value determination tables 72a to 72c in one-to-one correspondence with the plurality of system impedances A to C. Specifically, the control data storage section 172 stores the heating-element-temperature-based PWM value determination table 71a and the environmental-temperature-based PWM value determination table 72a corresponding to the system impedance A. The control data storage section 172 also stores the heating-element-temperature-based PWM value determination table 71b and the environmental-temperature-based PWM value determination table 72b corresponding to the system impedance B. The control data storage section 172 further stores the heating-element-temperature-based PWM value determination table 71c and the environmental-temperature-based PWM value determination table 72c corresponding to the system impedance C.

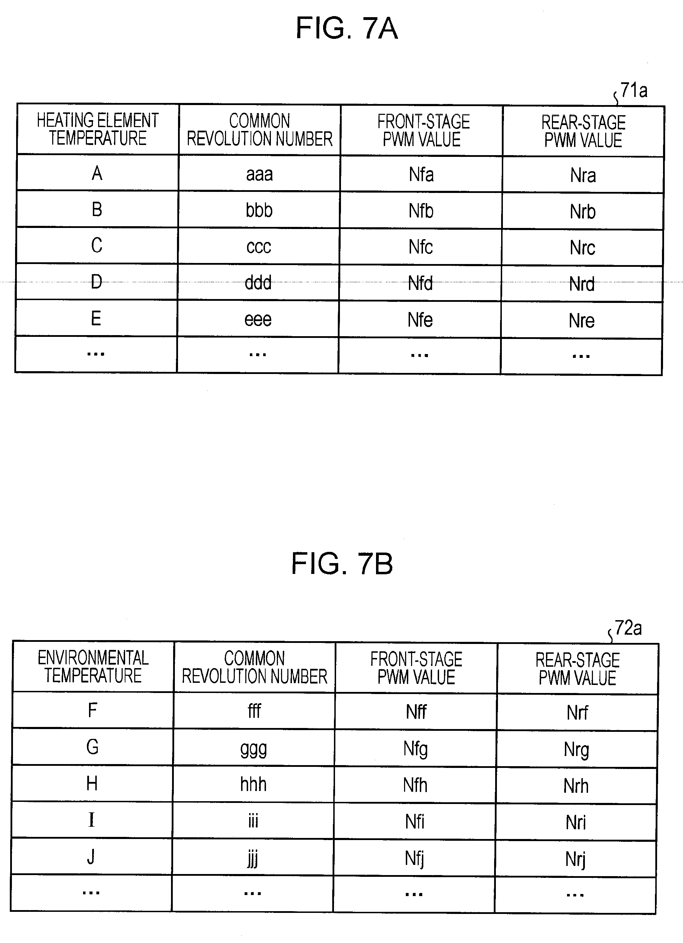

FIG. 7A illustrates an example of the heating-element-temperature-based PWM value determination table 71a. As illustrated in FIG. 7A, in the heating-element-temperature-based PWM value determination table 71a, heating element temperatures, common revolution numbers, front-stage PWM values and rear-stage PWM values are stored in one-to-one correspondence. For example, as illustrated in FIG. 7A, in the heating-element-temperature-based PWM value determination table 71 a, the common revolution number "aaa", the front-stage PWM value "Nfa" and the rear-stage PWM value "Nra" are stored corresponding to the heating element temperature "A". The heating element temperatures are stored in the form of predetermined variables output from the temperature check sections 12a and 12b in accordance with the temperatures of the heating elements 52a and 52b.

The common revolution number (min⁻¹) is a revolution number commonly set for the fans 3a and 3b in the case that an air flow rate needed for cooling the heating elements 52a and 52b is obtained in a state in which a difference in revolution number between the fans 3a and 3b is maintained in a predetermined tolerance. In the example illustrated in FIG. 7A, the needed air flow rate stored in the heating-element-temperature-based PWM value determination tables 71a to 71c is an air flow rate determined in accordance with temperatures of the heating elements 52a and 52b, a system impedance in the electronic equipment 50 and a total PQ characteristic (a static pressure-air flow rate characteristic) of the fans 3a and 3b obtained in a state in which the difference in revolution number between the fans 3a and 3b is maintained in the predetermined tolerance. Incidentally, the system impedance, the PQ characteristic and the common revolution number are obtained from thermal hydraulic simulation and measurement performed on the basis of measurement of temperatures of the heating elements 52a and 52b. Details thereof will be described later.

In this embodiment, the "predetermined tolerance" is a range in which the difference in revolution number between the front-stage fan 3a and the rear-stage fan 3b is less than 10%. That is, ideally, the noise generated from these fans 3a and 3b may be minimized by setting them to the same speed. However, even in the case that the revolution number of the front-stage fan 3a is slightly different from that of the rear-stage fan 3b, there is no problem so long as any excess noise is inaudible. In the case that the difference in revolution number between the front-stage fan 3a and the rear-stage fan 3b is 10%, the noise generated from these fans 3a and 3b is larger than the noise generated when the revolution numbers of the front-stage blower 3a and the rear-stage blower 3b are controlled to coincide with each other by about 3dB. Basically, it is said that the error of 3dB is not noticeable to the ear. Therefore, in this embodiment, the "predetermined tolerance" is defined as a range in which the difference in revolution number between the front-stage fan 3a and the rear-stage fan 3b is less than 10%.

However, some persons may notice a 3dB difference, so more preferably, the difference in revolution number between the front-stage blower 3a and the rear-stage blower 3b is set to be less than 5%, to keep the excess noise level down to about 1dB. As described above, a noise reduction effect which is equivalent to that attained when the revolution numbers of the front-stage fan 3a and the rear-stage fan 3b are controlled to coincide with each other may be more obtained by setting the "predetermined tolerance" to a range in which the difference in revolution number between the front-stage fan 3a and the rear-stage fan 3b is less than 5%.

The front-stage PWM value (s) is a PWM value of a pulse to be input into the front-stage fan 3a in order to rotate the front-stage fan 3a with a common revolution number. The rear-stage PWM value (s) is a PWM value of a pulse to be input into the rear-stage fan 3b in order to rotate the rear-stage fan 3b with the common revolution number. That is, for example, when the heating element temperature is "A", the pulse of the front-stage PWM value "Nfa" is input into the front-stage fan 3a and the pulse of the rear-stage PWM value "Nra" corresponding to the front-stage PWM value "Nfa" is input into the rear-stage fan 3b, thereby rotating the fans 3a and 3b with the common revolution number "aaa". These front-stage and rear-stage PWM values may be obtained from measurement performed in advance.

FIG. 7B illustrates an example of the environmental-temperature-based PWM value determination table 72a. As illustrated in FIG. 7B, environmental temperatures, common revolution numbers, front-stage PWM values and rear-stage PWM values are stored in the environmental-temperature-based PWM value determination table 72a in one-to-one correspondence. For example, as illustrated in FIG. 7B, the common revolution number "fff", the front-stage PWM value "Nff" and the rear-stage PWM value "Nrf" are stored in the environmental-temperature-based PWM value determination table 72a corresponding to the heating element temperature "F". In the example illustrated in the drawing, the environmental temperature is a temperature detected using the temperature sensor 11c.

The common revolution number is a revolution number which is commonly set for the fans 3a and 3b in order to obtain an air flow rate needed to cool the heating elements 52a and 52b in a state in which the difference in revolution number between the fans 3a and 3b is maintained in the predetermined tolerance as in the case in the heating-element-temperature-based PWM value determination tables 71a to 71 c. In the example illustrated in the drawing, the needed air flow rate stored in the environmental-temperature-based PWM value determination tables 72a to 72c is an air flow rate which is obtained in accordance with an environmental temperature, a system impedance in the electronic equipment 50 and a total PQ characteristic of the fans 3a and 3b obtained when a difference in revolution number between the fans 3a and 3b is in the predetermined tolerance.

The front-stage PWM value and the rear-stage PWM value are PWM values of pulses to be input into the front-stage fan 3a and the rear-stage fan 3b in order to rotate the front-stage fan 3a and the rear-stage fan 3b with a common revolution number as in the case in the heating-element-based PWM value determination tables 71a to 71c. That is, for example, with the heating element temperature "G", the pulse of the front-stage PWM value "Nfg" is input into the front-stage fan 3a and the pulse of the rear-stage PWM value "Nrg" corresponding to the front-stage PWM value "Nfg" is input into the rear-stage fan 3b to rotate the fans 3a and 3b with the common revolution number "ggg".

As described above, the control data storage section 172 corresponds to control data storage means and stores input values of pulses to be input into the fans 3a and 3b per temperature in order to obtain the air flow rate needed to cool the heating elements in a state in which the difference in revolution number between the fans 3a and 3b is maintained in the predetermined tolerance. In addition, the control data storage section 172 corresponds to control data storage means and stores input values of pulses to be input into the front-stage fan 3a and the rear-stage fan 3b per system impedance.

As illustrated in FIG. 4, the processor 18 includes an error processing section 181, a temperature information acquiring section 182, an input value determining section 183 and database preparing section 184.

The error processing section 181 executes an error notifying process on the basis of information acquired from the revolution number error check section 14. The error processing section 181 acquires a result of check indicating that the front-stage fan 3a or the rear-stage fan 3b is now in a stopped state from the revolution number error check section 14. The error processing section 181 then sends an error notification that the fan 3a or 3b is in the stopped state to the electronic equipment 50 on the basis of the result of check acquired. As a result, an error message that the fan 3a or 3b is now in the stopped state is displayed on a display not illustrated of the electronic equipment 50.

The temperature information acquiring section 182 acquires predetermined variables corresponding to temperatures of the heating elements 52a and 52b from the temperature check sections 12a and 12b as data indicative of the heating element temperatures. The temperature information acquiring section 182 also acquires the environmental temperature from the temperature sensor 12c. As described above, the temperature sensors 11 a and 11b, the temperature check sections 12a and 12b and the temperature information acquiring section 182 functions as an example of temperature detecting means for detecting the temperatures of the heating elements 52a and 52b installed in the electronic equipment 50. The temperature sensor 11c and the temperature information acquiring section 182 also function as an example of temperature detecting means for detecting the temperature outside of the electronic equipment 50.

The input value determining section 183 specifies a system impedance corresponding to the current configuration of the electronic equipment 50 with reference to data stored in the equipment state storage section 171. In addition, the input value determining section 183 acquires the respective PWM values of pulses to be input into the fans 3a and 3b from the control data storage section 172 on the basis of the specified system impedance and the heating element temperatures or the environmental temperature acquired from the temperature information acquiring section 182.

Specifically, the input value determining section 183 acquires a front-stage PWM value and a rear-stage PWM value corresponding to a combination of the specified system impedance with temperature information of the heating elements 52a and 52b acquired from the temperature information acquiring section 182 from the heating-element-temperature-based PWM value determination tables 71a to 71c. In addition, the input value determining section 183 acquires a front-stage PWM value and a rear-stage PWM value corresponding to a combination of the specified system impedance with environmental temperature information acquired from the temperature information acquiring section 182 from the environmental-temperature-based PWM value determination tables 72a to 72c.

For example, in the case that the specified system impedance is "A" and the heating element temperature acquired from the temperature information acquiring section 182 is "C", the input value determining section 183 acquires the front-stage PWM value "Nfc" and the rear-stage PWM value "Nrc" from the heating-element-temperature-based PWM value determination table 71a as illustrated in FIG. 7A.

The input value determining section 183 then instructs the pulse generator 15a to input the pulse of the acquired front-stage PWM value into the front-stage blower 3a and instructs the pulse generator 15b to input the pulse of the acquired rear-stage PWM value into the rear-stage blower 3b. In response to the instructions, the pulse generators 15a and 15b respectively input the pulses of the front-stage PWM value and rear-stage PWM value as instructed from the input value determining section 183 into the front-stage fan 3a and the rear-stage fan 3b. As a result, the front-stage fan 3a rotates with the revolution number conforming to the front-stage PWM value of the pulse input from the pulse generator 15a and the rear-stage fan 3b rotates with the revolution number conforming to the rear-stage PWM value of the pulse input from the pulse generator 15b.

Incidentally, as described above, the front-stage PWM value and the rear-stage PWM value are PWM values of pulses to be input into the fans 3a and 3b in order to obtain the needed air flow rate in a state in which the difference in revolution number between the fans 3a and 3b is maintained in the predetermined tolerance. Therefore, the difference in revolution number between the fans 3a and 3b is set in the predetermined tolerance by inputting pulses of the above mentioned front-stage and rear-stage PWM values into the respective fans 3a and 3b and air is fed into the equipment at the needed air flow rate conforming to the temperatures of the heating elements 52a and 52b.

As described above, in the fan control device 1 according to this embodiment, since the difference in revolution number between the fans 3a and 3b is maintained in the predetermined tolerance, that is, the revolution numbers of the fans 3a and 3b are controlled to coincide with each other in the predetermined tolerance, such a situation may be avoided that surplus noise is generated from a fan of the largest revolution number to increase the total noise from the fans 3a and 3b.

In addition, the needed air flow rate according to this embodiment is determined by taking the temperatures of the heating elements 52a and 52b, the system impedance within the electronic equipment 50 and the total PQ characteristic of the fans 3a and 3b obtained when the difference in revolution number between the fans 3a and 3b is maintained in the predetermined tolerance into consideration. Therefore, according to this embodiment, the air flow rate suitable for cooling the heating elements 52a and 52b may be obtained in a state in which the revolution numbers of the fans 3a and 3b are controlled to coincide with each other in the predetermined tolerance regardless of the configuration of the electronic equipment 50 concerned and the locations of the fans 3a and 3b in the electronic equipment 50.

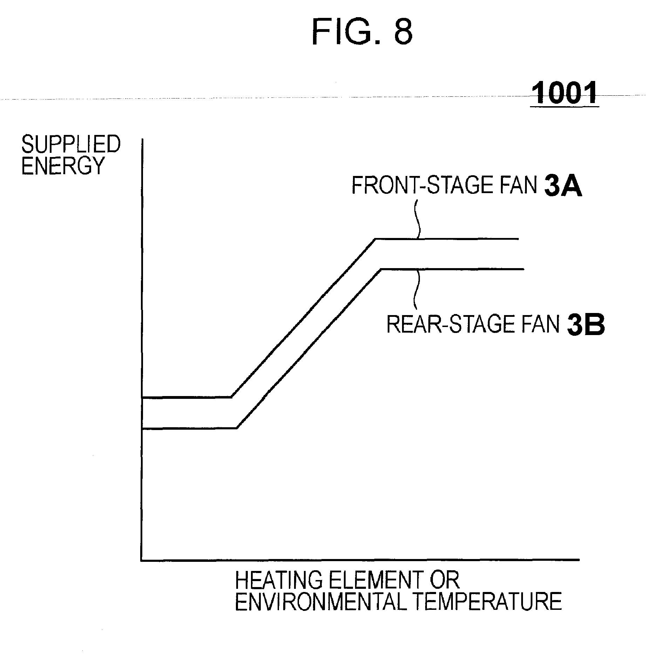

Incidentally, the input value determining section 183 determines different PWM values for the front-stage fan 3a and the rear-stage fan 3b and inputs pulses of the determined PWM values into the fans 3a and 3b via the pulse generators 15a and 15b. That is, as illustrated the graph 1001 in FIG. 8, different amounts of energy 1010 are supplied to the front-stage fan 3a and the rear-stage fan 3b. Specifically, the work amount of the rear-stage fan 3b is reduced influenced by the air currents generated from the front-stage fan 3a, so that the amount of energy supplied to the rear-stage fan 3b becomes smaller than that supplied to the front-stage fan 3a in the case that the revolution numbers of the fans 3a and 3b are controlled to coincide with each other.

In addition, in the case that the common revolution number obtained on the basis of the environmental temperature is larger than the common revolution number obtained on the basis of the heating element temperatures, the input value determining section 183 controls the revolutions numbers of the fans 3a and 3b by using the environmental-temperature-based PWM values. Specifically, the input value determining section 183 acquires common revolution numbers corresponding to the environmental temperature and the heating element temperatures acquired from the temperature information acquiring section respectively from the environmental-temperature-based PWM determination tables 72a to 72c and the heating-element-temperature-based PWM value determination tables 71a to 71c. The input value determining section 183 then compares a common revolution number obtained from the environmental temperature with a common revolution number obtained from the heating element temperatures, and in the case that the common revolution number obtained from the environmental temperature is larger than that obtained from the heating element temperatures, acquires the front-stage PWM value and the rear-stage PWM value corresponding to the environmental temperature concerned from the environmental-temperature-based PWM value determination tables 72a to 72c. As described above, the revolution numbers of the fans 3a and 3b are controlled on the basis of one of the environmental temperature and the heating element temperatures which will influence the heating elements 52a and 52b more greatly than another, so that the heating elements 52a and 52b may be maintained at more appropriate temperatures.

As described above, the input value determining section 183 and the equipment state storage section 171 function as an example of equipment state acquiring means for acquiring information on the system impedance within the electronic equipment 50. In addition, the input value determining section 183 and the pulse generators 15a and 15b function as an example of control means for controlling the revolution number of each fan on the basis of the temperature information acquired using the temperature information acquiring section 182 such that the air flow rate of air for cooling the heating elements 52a and 52b which is determined in accordance with the temperatures of the heating elements 52a and 52b, the system impedance within the electronic equipment 50 and the total static pressure-air flow rate characteristic of the fans 3a and 3b attained when the difference in revolution number between the fans 3a and 3b is maintained in the predetermined tolerance may be obtained and the difference in revolution number between the fans 3a and 3b may be set in the predetermined tolerance.

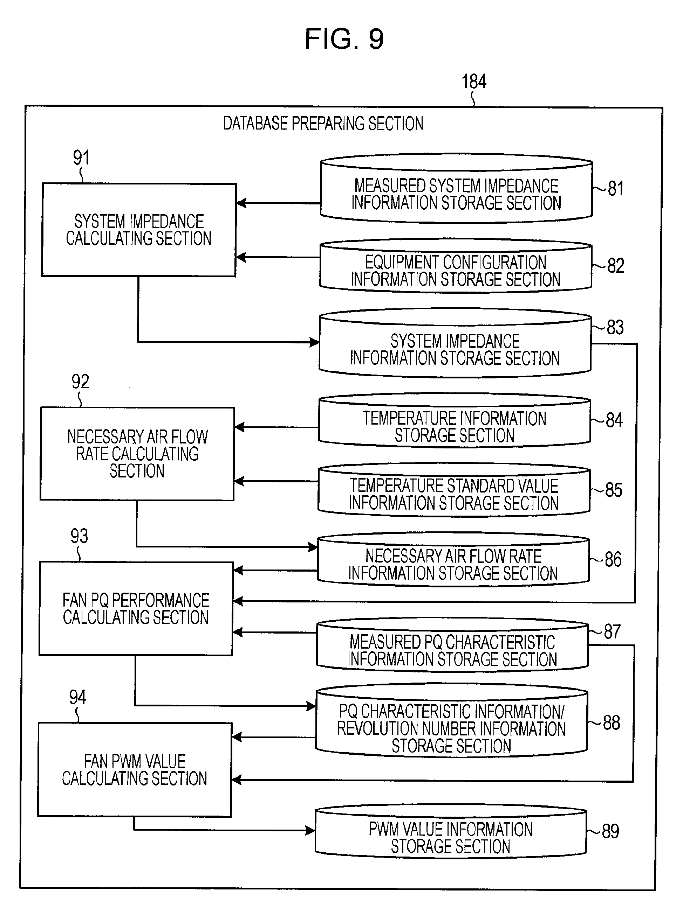

The database preparing section 184 executes various calculating processes in order to prepare the heating-element-temperature-based PWM value determination tables 71a to 781c and the environmental-temperature-based PWM value determination tables 72a to 72c before the fan control device is incorporated into the electronic equipment 50. Next, a specific configuration of the database preparing section 184 will be described. FIG. 9 is a block diagram illustrating a specific configuration of the database preparing section according to the embodiment 2.

As illustrated in FIG. 9, the database preparing section 184 includes a measured (already measured) system impedance information storage section 81, an equipment configuration information storage section 82, a system impedance information storage section 83, a temperature information storage section 84 and a temperature standard value information storage section 85. The database preparing section 184 also includes a needed air flow rate information storage section 86, a measured (already measured) PQ characteristic information storage section 87, a PQ characteristic information and revolution number information storage section 88 and a PWM value information storage section 89. The database preparing section 184 further includes a system impedance calculating section 91, a needed air flow rate calculating section 92, a fan PQ performance calculating section 93 and a fan PWM value calculating section 94.

The measured system impedance information storage section 81 stores measured system impedances of the electronic equipment 50. For example, the measured system impedance information storage section 81 stores system impedances corresponding to full configurations and popular configurations of the electronic equipment 50. The equipment configuration information storage section 82 stores a plurality of patterns of configurations of the electronic equipment 50. For example, the equipment configuration information storage section 82 stores information on the number of CPUs and the number of power sources which are built into the electronic equipment 50 per configuration of the electronic equipment 50. The system impedance information storage section 83 stores system impedances which are calculated per configuration of the electronic equipment 50 using the system impedance calculating section 91.

The temperature information storage section 84 stores the environmental temperature and the temperatures of the heating elements 5a and 52b. For example, the temperature information storage section 84 stores the temperatures of the CPUs and memories built into the electronic equipment as the temperatures of the heating element 52a and 52b. The temperature standard value information storage section 85 stores standard values of temperatures of the heating elements 52a and 52b. The needed air flow rate information storage section 86 stores the needed air flow rates calculated using the needed air flow rate calculating section 92.

The measured PQ characteristic information storage section 87 stores the information on the maximum and minimum revolution numbers of the fans 3a and 3b. The PQ characteristic information and revolution number information storage section 88 stores the total PQ characteristic of the fans 3a and 3b and the common revolution numbers of the fans 3a and 3b calculated using the fan PQ performance calculating section 93. The PWM value information storage section 89 stores the front-stage PWM values and rear-stage PWM values calculated using the fan PWM value calculating section 94.

The system impedance calculating section 91 calculates each system impedance of each configuration of the electronic equipment 50 on the basis of the information on the measured system impedances stored in the measured system impedance information storage section 81 and the information on the configurations of the electronic equipment 50 stored in the equipment configuration information storage section 82. The needed air flow rate calculating section 92 calculates the needed air flow rates on the basis of the temperatures stored in the temperature information storage section 84 and the temperature standard values stored in the temperature standard value information storage section 85.

The fan PQ performance calculating section 93 calculates the total PQ characteristic of the fans 3a and 3b and the common revolution numbers of the fans 3a and 3b. The calculation is performed on the basis of information on the system impedances stored in the system impedance information storage section 83, the needed air flow rates stored in the needed air flow rate information storage section 86 and the maximum and minimum revolution numbers of the fans 3a and 3b stored in the measured PQ characteristic information storage section 87. The fan PWM value calculating section 94 calculates the front-stage PWM values and rear-stage PWM values. The calculation is performed on the basis of information on the maximum and minimum revolution numbers of the fans 3a and 3b stored in the measured PQ characteristic information storage section 87 and the total PQ characteristic of the fans 3a and 3b and the common revolution numbers of the fans 3a and 3b stored in the PQ characteristic information and revolution number information storage section 88.

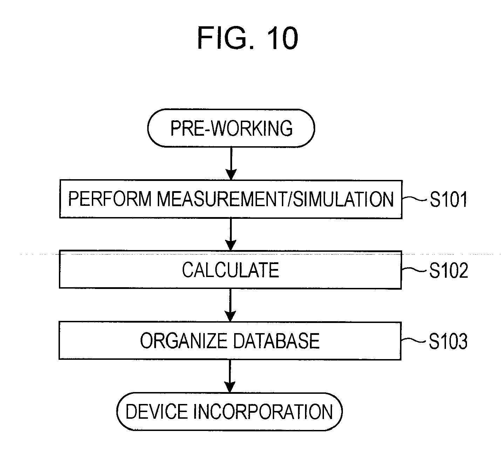

Next, procedures of preparing the heating-element-temperature-based PWM value determination tables 71a to 71c and the environmental-temperature-based PWM value determination tables 72a to 72c will be described. FIG. 10 is a flowchart illustrating an example of procedures of preparing the heating-element-temperature-based PWM value determination tables 71a to 71c and the environmental-temperature-based PWM value determination tables 72a to 72c.

As illustrated in FIG. 10, as work to be previously performed in preparation of the heating-element-temperature-based PWM value determination tables 71a to 71c and the environmental-temperature-based PWM value determination tables 72a to 72c, first, measurement and simulation are performed (step S101). Specifically, system impedances corresponding to the full and popular configurations of the electronic equipment, and maximum and minimum revolution numbers, air flow rates, static pressures and noise levels of the fans 3a and 3b are obtained by the measurement and simulation.

Next, various calculations are performed on the basis of the information obtained at step S101 using the database preparing section 184 (step S102). Specifically, each system impedance of each equipment configuration and each needed air flow rate, each common revolution number, each front-stage PWM value and each rear-stage PWM value at each temperature are calculated (step 102).

Then, each system impedance calculated for each equipment configuration and each needed air flow rate, each common revolution number, each front-stage PWM value and each rear-stage PWM value which are calculated at each of the environmental temperature and the heating element temperatures are arranged in the form of databases and stored in the ROM 17 (step S103). Owing to the above mentioned operations, the heating-element-temperature-based PWM value determination tables 71a to 71c and the environmental-temperature-based PWM value determination tables 72a to 72c are stored in the ROM 17. The fan control device 1 is then incorporated into the electronic equipment 50 in a state in which the heating-element-temperature-based PWM value determination tables 71a to 71c and the environmental-temperature-based PWM value determination tables 72a to 72c are stored in the ROM 17.

Next, specific operations of the processor 18 according to this embodiment will be described.

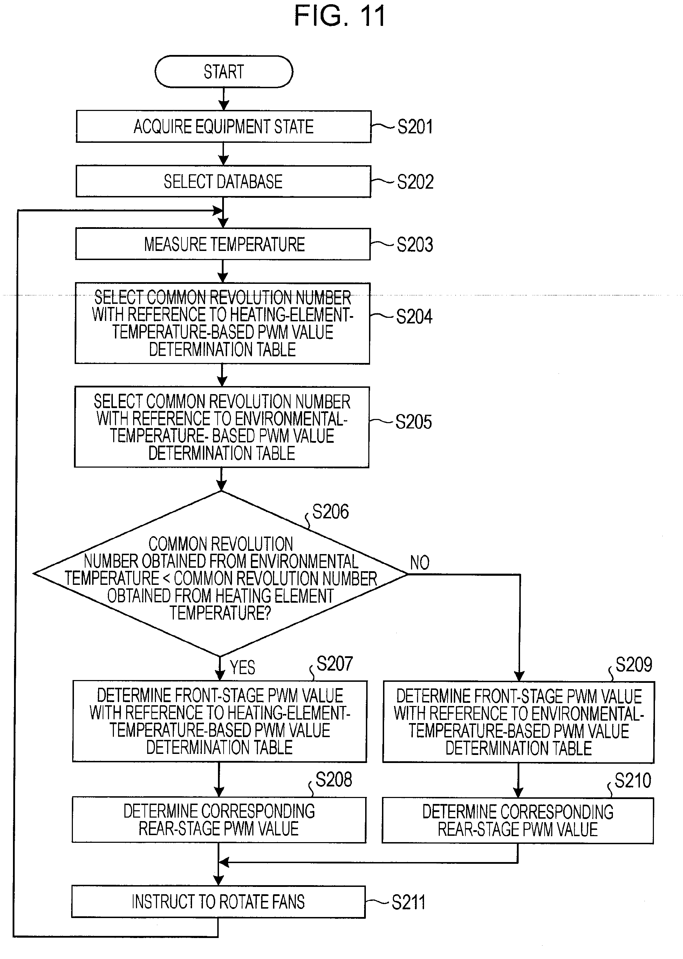

FIG. 11 is a flowchart illustrating an example of procedures of processing executed using the processor according to the embodiment 2. Incidentally, only a procedure involving revolution number control of the front-stage fan 3a and the rear-stage fan 3b of the procedures of processing executed using the processor 18 is illustrated in FIG. 11.

As illustrated in FIG. 11, first, the input value determining section 183 acquires an equipment state (step S201). Specifically, the input value determining section 183 specifies a system impedance to which an equipment state specification flag is set as the system impedance corresponding to the current configuration of the electronic equipment 50 with reference to data stored in the equipment state storage section 171.

Next, the input value determining section 183 selects a database corresponding to the specified system impedance (step S202). Specifically, the input value determining section 183 selects one heating-element-temperature-based PWM value determination table from within the heating-element-temperature-based PWM value determination tables 71a to 71c and one environmental-temperature-based PWM value determination table from within the environmental-temperature-based PWM value determination tables 72a to 72c.

Next, the processor 18 executes temperature measurement (step S203). Specifically, the temperature information acquiring section 182 acquires predetermined variables corresponding to temperatures of the heating elements 52a and 52b from the temperature check sections 12a and 12b as heating element temperatures and acquires an environmental temperature from the temperature sensor 12c. The temperature information acquiring section 182 then notifies the input value determining section 183 of the acquired heating element and environmental temperatures.

Next, the input value determining section 183 selects a common revolution number corresponding to the heating element temperatures acquired at step S203 with reference to the heating-element-temperature-based PWM determination table (step S204). The input value determining section 183 also selects a common revolution number corresponding to the environmental temperature acquired at step S203 with reference to the environmental-temperature-based PWM value determination table (step S205).

Next, the input value determining section 183 judges whether the heating-element-temperature-based common revolution number is larger than the environmental-temperature-based common revolution number (step S206). In the above mentioned process, in the case that it has been judged that the common revolution number obtained from the heating element temperature is larger than the common revolution number obtained from the environmental temperature (Yes at step S206), the input value determining section 183 determines the PWM values of pulses to be input into the fans 3a and 3b using the heating-element-temperature-based PWM value determination table 71.

Specifically, the input value determining section 183 determines the front-stage PWM value corresponding to the common revolution number selected at step S204 with reference to the heating-element-temperature-based PWM value determination table 71 (step S207). The input value determining section 183 then determines the rear-stage PWM value corresponding to the front-stage PWM value with reference to the heating-element-temperature-based PWM value determination table 71 (step S208). For example, in the case that the current system impedance of the electronic equipment 50 is "A" and the heating element temperature acquired using the temperature information acquiring section 182 is "C", the input value determining section 183 selects the common revolution number "ccc" with reference to the heating-element-temperature-based PWM value determination table 71a illustrated in FIG. 7A. Then, the input value determining section 183 determines the front-stage PWM value "Nfc" and the rear-stage PWM value "Nrc" corresponding to the common revolution number "ccc" as the PWM values of the pulses to be input into the fans 3a and 3b.

On the other hand, at step S204, it has been judged that the heating-element-temperature-based common revolution number is not larger than the environmental-temperature-based common revolution number (No at step S206); the input value determining section 183 determines the PWM values of pulses to be input into the fans 3a and 3b by using the heating-element-temperature-based PWM value determination table 71.

Specifically, the input value determining section 183 determines a front-stage PWM value corresponding to the common revolution number selected at step S205 with reference to the environmental-temperature-based PWM value determination table 72 (step S209). The input value determining section 183 determines a rear-stage PWM value corresponding to the front-stage PWM value with reference to the heating-element-temperature-based PWM value determination table 71 (step S210). For example, in the case that the current system impedance of the electronic equipment 50 is "A" and the environmental temperature acquired using the temperature information acquiring section 182 is "G", the input value determining section 183 selects the common revolution number "ggg" with reference to the environmental-temperature-based PWM value determination table 72a as illustrated in FIG. 7B. The input value determining section 183 then determines the front-stage PWM value "Nfg" and the rear-stage PWM value "Nrg" corresponding to the common revolution number "ggg" as the PWM values of pulses to be input into the fans 3a and 3b.

At the completion of execution of the process at step S208 or step S210, the input value determining section 183 instructs to rotate the fans (step S211). That is, the input value determining section 183 instructs the pulse generators 15a and 15b to input pulses of the front-stage and rear-stage PWM values determined at steps S207 and S208 or at steps S209 and S210 respectively into the front-stage fan 3a and the rear-stage fan 3b. In response to the instruction, the pulse generator 15a inputs the pulse of the above front-stage PWM value into the front-stage fan 3a as instructed from the input value determining section 183. Likewise, the pulse generator 15b inputs the pulse of the above rear-stage PWM value into the rear-stage fan 3b as instructed from the input value determining section 183. As a result, the front-stage fan 3a and the rear-stage fan 3b rotate with the revolution numbers corresponding to the front-stage PWM value and the rear-state PWM value which have been input from the pulse generators 15a and 15b.

Incidentally, as described above, the front-stage PWM value and the rear-stage PWM value are PWM values of pulses to be input into the fans 3a and 3b in order to obtain the needed air flow rate in a state in which the difference in revolution number between the fans 3a and 3b is maintained in the predetermined tolerance. Therefore, the fans 3a and 3b rotate in a state in which the revolution numbers of the fans coincide with each other in the predetermined tolerance by inputting the pulses of the above front-stage and rear-stage PWM values respectively into the fans 3a and 3b and air is fed into the heating elements 52a and 52b at the needed air flow rates conforming to the temperatures of the heating elements 52a and 52b.

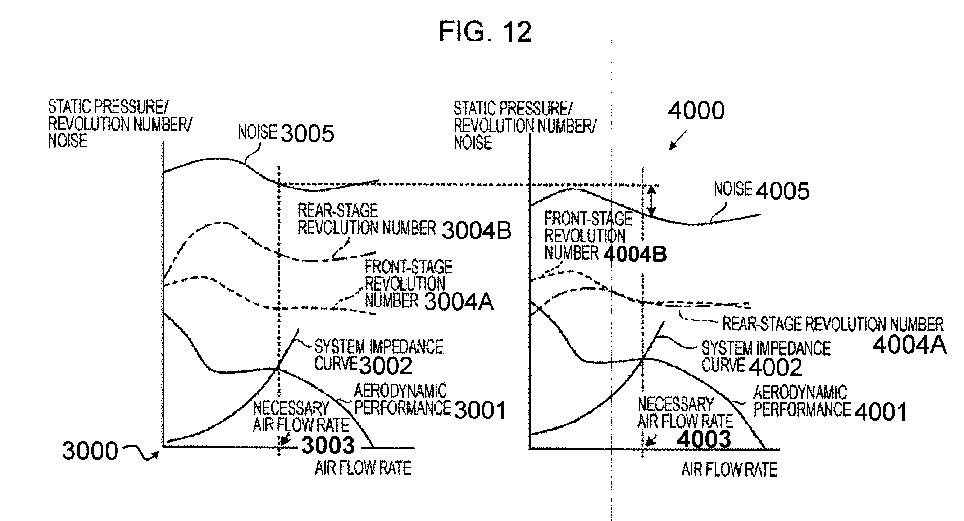

FIG. 12 is a diagram illustrating an effect of the embodiment. In FIG. 12, a left part is a graph indicative of changes in static pressure, revolution number and noise relative to a change in air flow rate obtained when the PWM values of the pulses applied to the front-stage fan 3a and the rear-stage fan 3b are made the same as each other at a predetermined temperature.

As illustrated in the graph, in the case that pulses of the same PWM value have been applied to the fans 3a and 3b, if it is intended to obtain a needed air flow rate 3003 at which the total aerodynamic performance 3001 of the fans 3a and 3b intersects the system impedance 3002, the revolution number of the rear-stage fan 3b (the rear-stage revolution number 3004B) will become larger than the revolution number of the front-stage fan 3a (the front-stage revolution number 3004A). The reason therefore lies in the fact that the work amount with which the rear-stage fan 3b blows off air is reduced under the influence of the air currents generated from the front-stage fan 3a to increase the revolution number of the rear-stage fan 3b. The noise 3005 is also increased with increasing the revolution number of the rear-stage fan 3b.

On the other hand, in FIG. 12, a right part is a graph indicative of changes in static pressure, revolution number and noise relative to a change in air flow rate obtained in the case that the fan control device 1 according to this embodiment has controlled such that the difference in revolution number (4004A, 4004B) between the front-stage fan 3a and the rear-stage fan 3b is maintained in the predetermined tolerance at a predetermined temperature. As illustrated in this graph, according to this embodiment, it may become possible to obtain the needed air flow rate 4003 at which the system impedance 4002 within the electronic equipment 50 intersects the total aerodynamic characteristic 4001 (the PQ characteristic) of the fans 3a and 3b when the difference in revolution number between the fans 3a and 3b is maintained in the predetermined tolerance in a state in which the difference in revolution number between the fans is set in the predetermined tolerance at the predetermined temperature.

Therefore, according to this embodiment, speed differences among fans, sufficient to audibly increase the noise level, can be avoided. In addition, according to this embodiment, the air flow rate suited to cool the heating elements 52a and 52b may be obtained in a state in which the difference in revolution number between the fans 3a and 3b is maintained in the predetermined tolerance regardless of the configuration of the electronic equipment 50 and the locations of the fans 3a and 3b within the electronic equipment 3a and 3b.

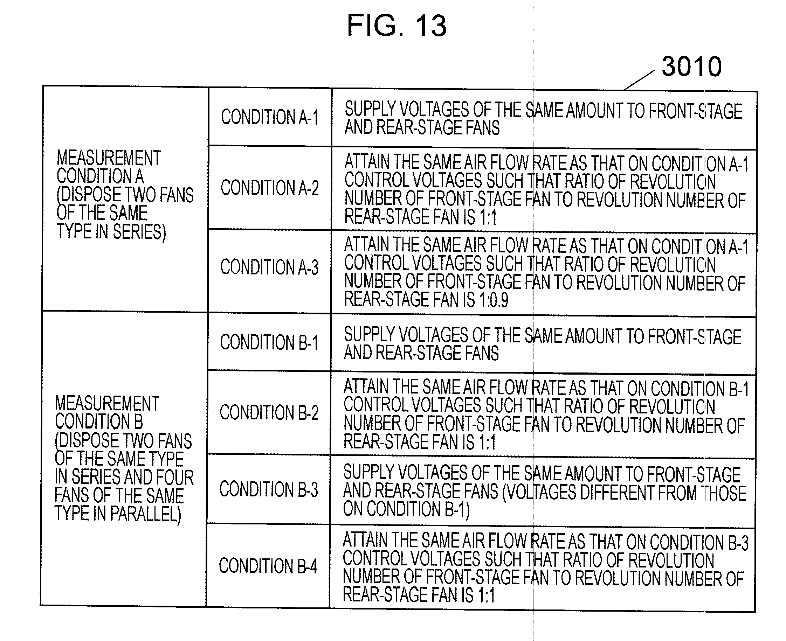

Next, results of experiments performed to validate that the noise generated from the plurality of fans 3a and 3b is reduced by using the fan control device 1 according to this embodiment will be described. Respective measurement conditions 3010 are illustrated in FIG. 13. FIG. 13 illustrates measurement conditions of the experiments for validation. As illustrated in FIG. 13, a case in which two fans of the same type are disposed in series is assumed to be a measurement condition A and a case in which two fans of the same type are disposed in series and four fans of the same type are disposed in parallel is assumed to be a measurement condition B.

Under the measurement condition A, experiments were performed under three conditions of conditions A-1 to A-3. Specifically, under the condition A-1, voltages of the same amount were supplied to the front-stage and rear-stage fans. Under the condition A-2, the same air flow rate as that under the condition A-1 was set and voltages were controlled such that the ratio of the front-stage fan revolution number to the rear-stage fan revolution number is 1:1. The condition A-2 corresponds to a condition under which the same control as that performed using the fan control device 1 according to this embodiment is performed. Under the condition A-3, the same air flow rate at that under the condition A-1 was set and voltages were controlled such that the ratio of the front-stage fan revolution number to the rear-stage fan revolution number is 1: 0.9.

In addition, as illustrated in FIG. 13, under the measurement condition B, experiments were performed under four conditions of conditions B-1, B-2, B-3 and B-4. Specifically, under the condition B-1, voltages of the same amount were supplied to the front-stage and rear-stage fans. Under the condition B-2, the same air flow rate as that under the condition B-1 was set and voltages were controlled such that the ratio of the front-stage fan evolution number to the rear-stage fan revolution number is 1:1. The condition B-2 corresponds to a condition under which the same control as that performed using the fan control device 1 according to this embodiment is performed.

Under the condition B-3, voltages of the same amount which is different from that of the voltages supplied under the condition B-1 were supplied to the front-stage and rear-stage fans. Under the condition B-4, the same air flow rate as that under the condition B-3 was set and voltages were controlled such that the ratio of the front-stage fan revolution number to the rear-stage fan revolution number is 1:1. The condition B-4 corresponds to a condition under which the same control as that performed using the fan control device 1 according to this embodiment is performed.

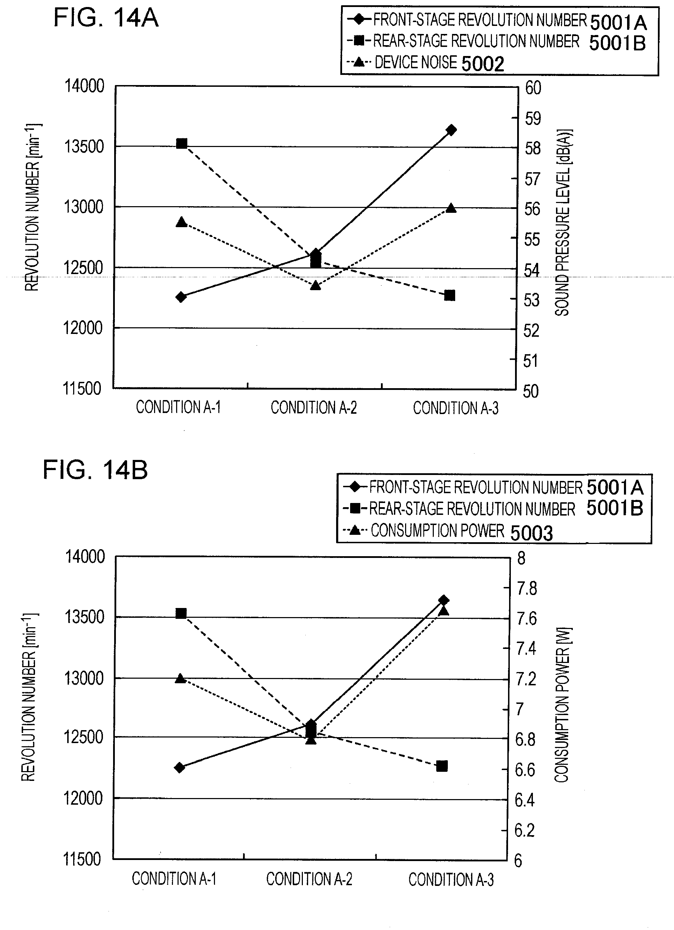

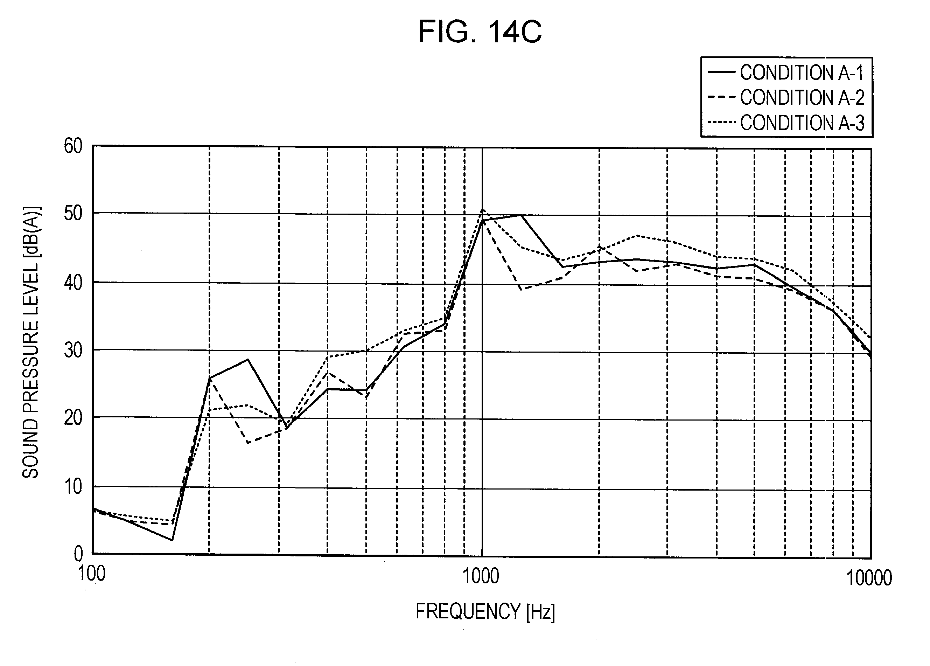

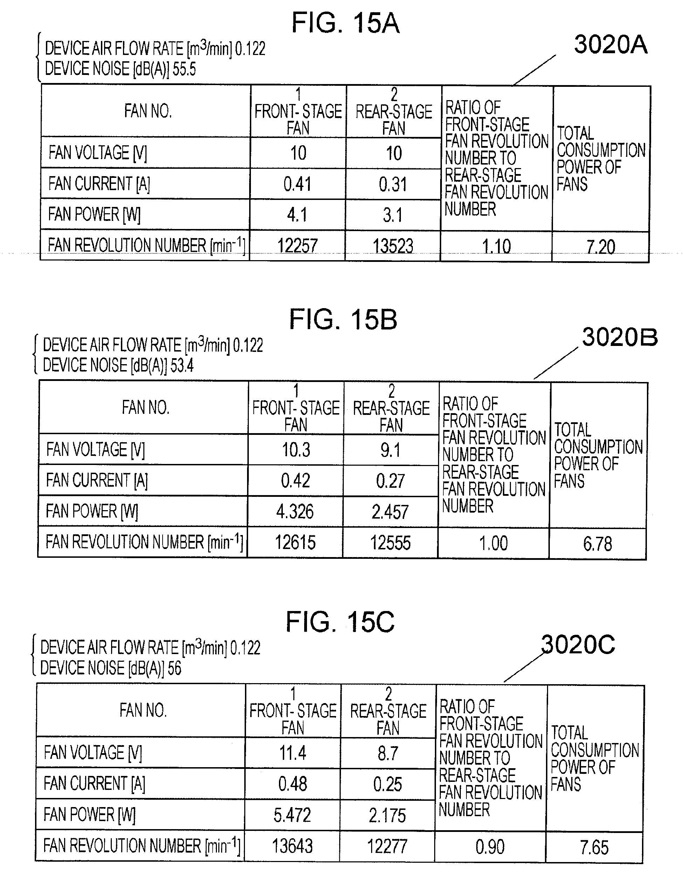

First, results of measurements performed under the measurement condition A will be described. FIG. 14A illustrates data indicative of the result of measurement of the front-stage fan revolution number 5001A, the rear-stage fan revolution number 5001B and the device noise 5002 performed under the measurement condition A. FIG. 14B illustrates data indicative of the result of measurement of the front-stage fan revolution number 6001A, the rear-stage fan revolution number 6001B and the consumption power 6002performed under the measurement condition A. FIG. 14C illustrates data indicative of the result of frequency analysis of the device noise performed under the measurement condition A. FIG. 15A is a diagram 3020Aillustrating a result of measurement performed under the condition A-1, FIG. 15B is a diagram 3020B illustrating a result of measurement performed under the condition A-2 and FIG. 15C is a diagram 3020C illustrating a result of measurement performed under the condition A-3.

As illustrated in Figs. 14A and 15A, under the condition A-1, the front-stage revolution number 5001A was 12257 min⁻¹ and the rear-stage revolution number 5001B was 13523 min⁻¹, indicating that in the case that voltages of the same amount have been supplied to the front-stage and rear-stage fans, the rear-stage fan revolution number 5001 B is increased influenced by air currents generated from the front-stage fan. As illustrated in Figs. 14A and 15C, under the condition A-3, the front-stage revolution number was 13643 min⁻¹ and the rear-stage revolution number was 12277 min⁻¹, indicating that the front-stage fan revolution number measured under the condition A-3 is larger than the rear-stage fan revolution number measured under the condition A-1. On the other hand, as illustrated in FIG. 14B and 15B, under the condition A-2, the front-stage revolution number was 12615 min⁻¹ and the rear-stage revolution number was 12555 min⁻¹, indicating that these revolution numbers are smaller than the rear-stage revolution number measured under the condition A-1 and the front-stage revolution number measured under the condition A-3.

In addition, as illustrated in FIG. 14A and Figs. 15A to 15C, the device noise 5002 measured under the condition A -1 was 55.5 dB (A), the device noise 5002 measured under the condition A-2 was 53.4 dB(A) and the device noise 5002 measured under the condition A-3 was 56 dB(A). That is, the device noise was the lowest when measured under the condition A-2 corresponding to a control system of the fan control device 1 according to this embodiment and was reduced from the value measured under the condition A-1 by about 2 dB(A). On the other hand, the highest device noise 5002 was measured under the condition A-3. It is thought that the reason therefore lies in the fact that the front-stage revolution number 5001A measured under the condition A-3 exhibited the highest value of the values measured under the respective conditions A-1 to A-3.

As described above, the noise generated from each fan may be reduced by controlling so as to attain a needed air flow rate in a state in which the revolution numbers of the front-stage and rear-stage fans (5001A, 5001B) are controlled to coincide with each other in the predetermined tolerance as in the case with the fan control device 1 according to this embodiment. Incidentally, the device noise 5002 under each of the conditions A-1 to A-3 is of a value calculated on the basis of the result of analysis of the frequency of the device noise illustrated in FIG. 14C.

In addition, as illustrated in FIG. 14B and Figs. 15A to 15C, the total consumption power 5003 of the front-stage and rear-stage fans was 7.20 W under the condition A-1, was 6.78 W under the condition A-2 and was 7.65 W under the condition A-3. That is, as in the case of the device noise 5002 the total consumption power 5003 was also the lowest when measured under the condition A-2 corresponding to that of the control system of the fan control device 1 according this embodiment and was reduced from the value measured under the condition A-1 by about 6%. As described above, the consumption power 5003 of each fan may be reduced by controlling so as to attain the needed air flow rate in a state in which the revolution numbers of the front-stage and rear-stage fans (5001A, 5001B) are controlled to coincide with each other in the predetermined tolerance as in the case with the fan control device 1 according to this embodiment.

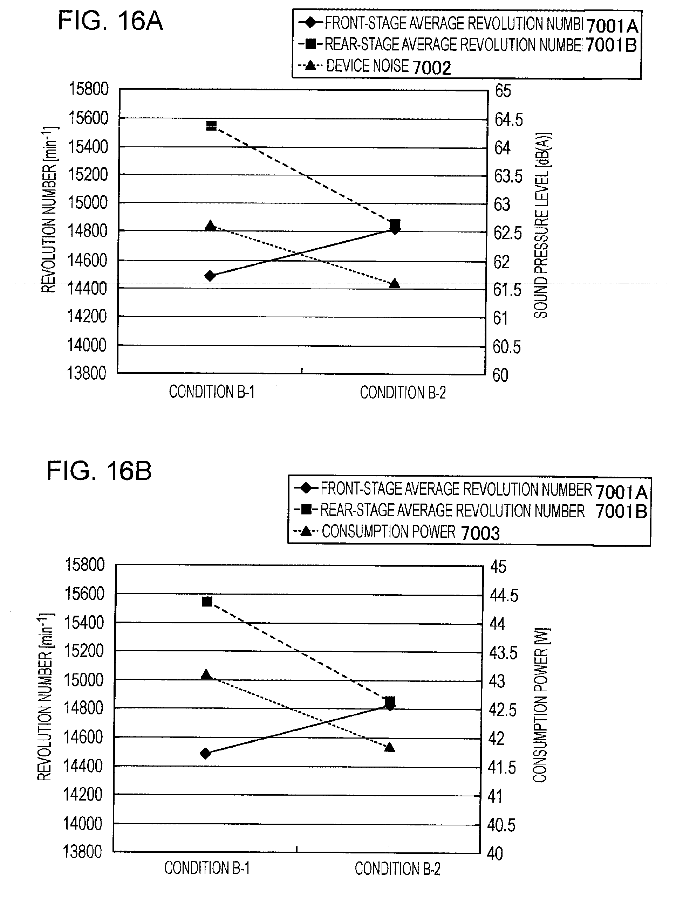

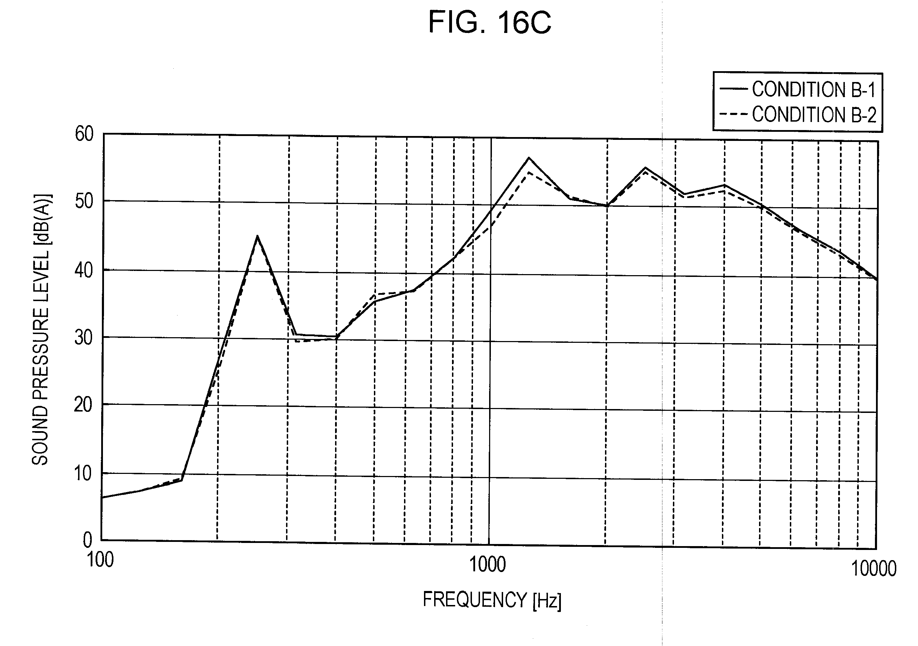

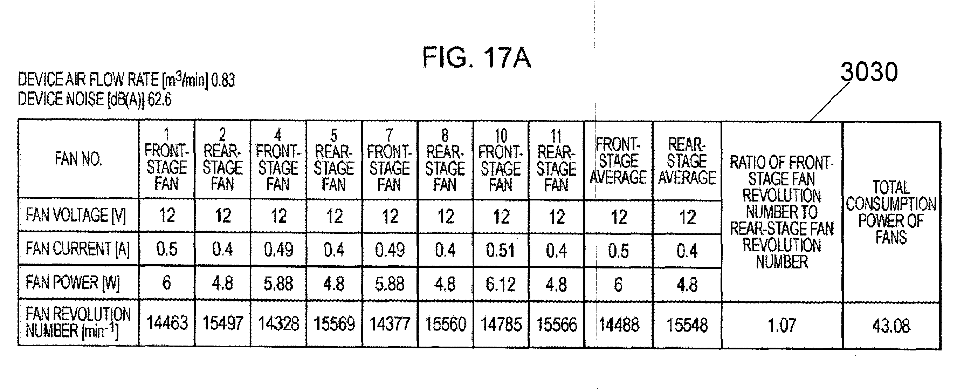

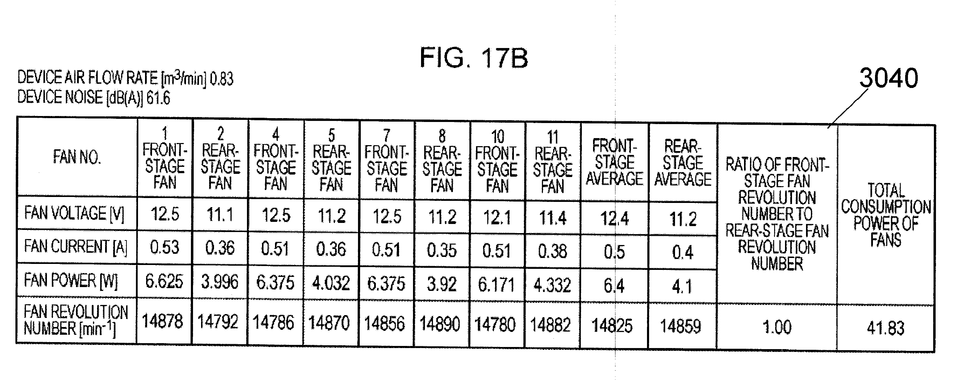

Next, results of measurements performed under the measurement condition B will be described. First, the results of measurements performed under the conditions B-1 and B-2 will be described. FIG. 16A illustrates data indicative of the result of measurement of the front-stage average revolution number 7001 A, the rear-stage average revolution number 7002A and the device noise 7003 performed under the conditions B-1 and B-2. FIG. 16B illustrates data indicative of the result of measurement of the front-stage average revolution number 7001A, the rear-stage average revolution number 7001B and the consumption power 7003 performed under the conditions B-1 and B-2. FIG. 16C illustrates data indicative of the result of frequency analysis of the device noise 7002 performed under the conditions B-1 and B-2. FIG. 17A is a diagram 3030 illustrating the result of measurement performed under the condition B-1 and FIG. 17B is a diagram 3040 illustrating the result of measurement performed under the condition B-2. In the examples illustrated in the drawings, the front-stage average revolution number 7001A is the average value of revolution numbers of four front-stage fans and the rear-stage average revolution number 7001B is the average value of revolution numbers of four rear-stage fans.

As illustrated in Figs. 16A and 17A, the front-stage average revolution number 7001A was 14488 min⁻¹ and the rear-stage average revolution number 7001B was 15548 min⁻¹ under the condition B-1. These values indicate that in the case that the voltages of the same amount have been supplied to the front-stage fan and the rear-stage fan as in the case under the condition A-1, the revolution number of the rear-stage fan 7001B is increased influenced by the air currents generated from the front-stage fan. On the other hand, as illustrated in Figs. 16A and 17B, the front-stage average revolution number 7001A was 14825 min⁻¹ and the rear-stage average revolution number 7001 B was 14859 min⁻¹ under the condition B-2. These revolution numbers 7001A, 7001B are smaller than the rear-stage average revolution number measured under the condition B-1.

As illustrated in FIG. 16A and Figs. 17A and 17B, the device noise 7002 under the condition B-1 was 62.6 dB(A) and the device noise 7002 under the condition B-2 was 61.6 dB(A). That is, as in the case under the measurement condition A, the device noise 7002 measured under the condition B-2 which is the same as that of the fan control device 1 according to this embodiment was lower than that measured under the condition B-1 and was reduced from the value measured under the condition B-1 by about 1 db(A).

As described above, even when the front-stage fans and the rear-stage fans are disposed in series and in parallel, an effect equivalent to that attained when the front-stage fan and the rear-stage fan are disposed only in series is obtained. Incidentally, the values of the device noise illustrated in FIG. 16A were calculated on the basis of the result of analysis of the frequency of the device noise 7002 illustrated in FIG. 16C.

In addition, as illustrated in FIG. 16B and Figs. 17A and 17B, the total consumption power 7003 of the front-stage and rear-stage fans was 43.08 W under the condition B-1 and was 41.83 W under the condition B-2. That is, the total consumption power 7003 was the lowest when measured under the condition B-2 corresponding to that of the fan control device 1 according to this embodiment and was reduced from the value measured under the condition B-1 by about 3%.

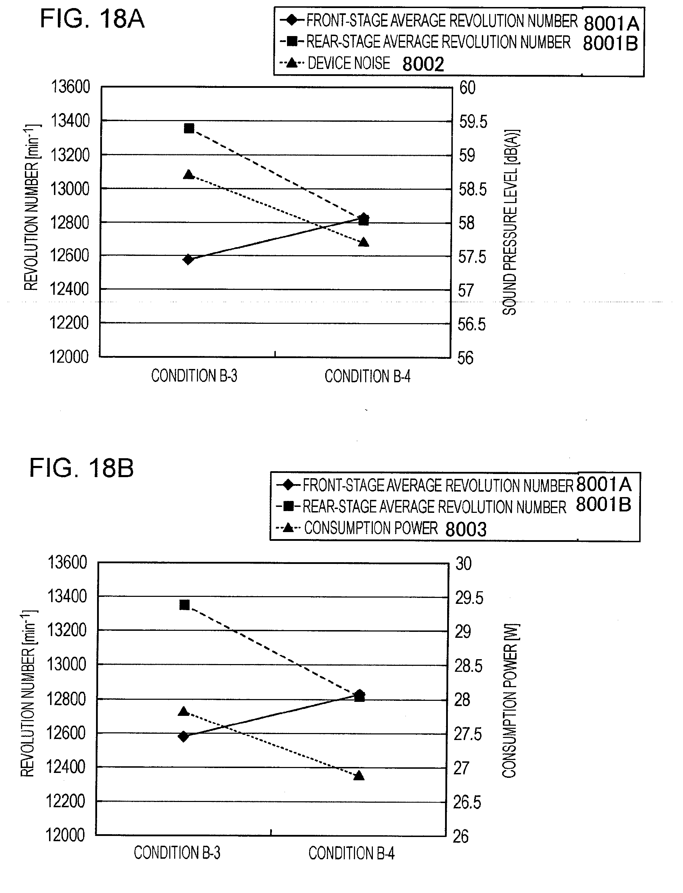

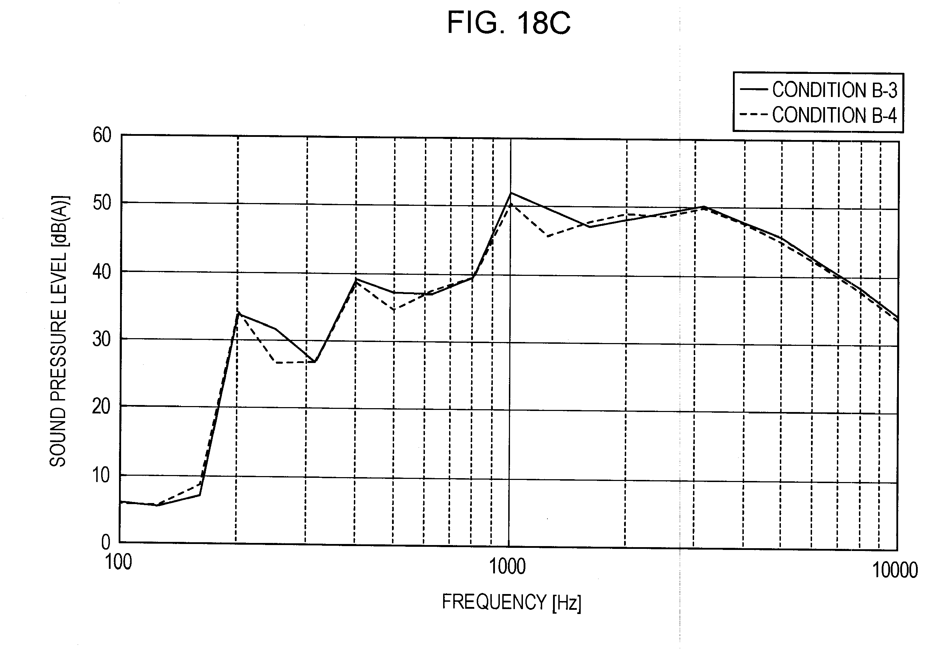

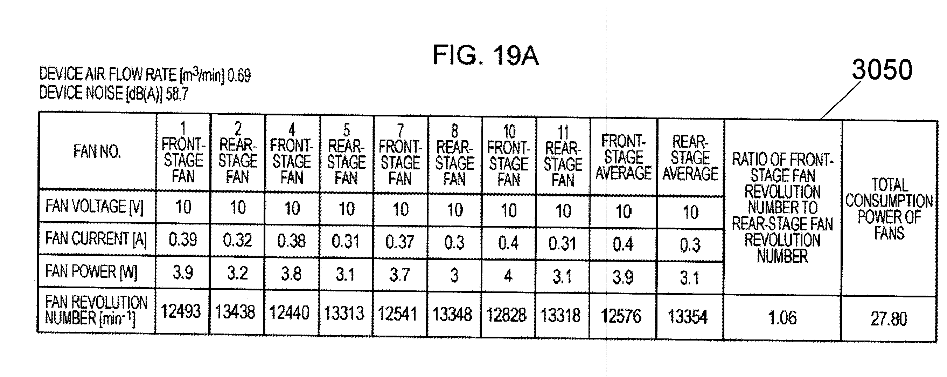

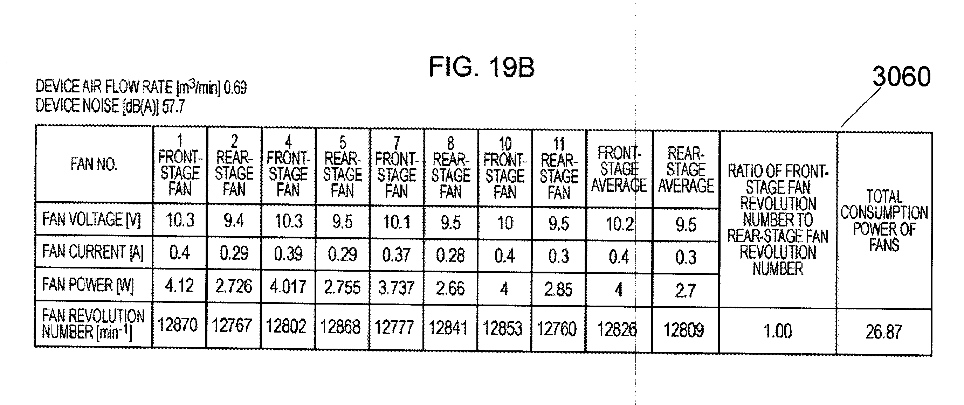

Next, results of measurements performed under the conditions B-3 and B-4 will be described. FIG. 18A illustrates data indicative of the result of measurement of the front-stage average revolution number 8001A, the rear-stage average revolution number 8001B and the device noise 8002 performed under the conditions B-3 and B-4, FIG. 18B illustrates data indicative of the result of measurement of the front-stage average revolution number 8001A, the rear-stage average revolution number 8001B and the consumption power 8003 performed under the conditions 18-3 and 18-4 and FIG. 18C illustrates data indicative of the result of analysis of the frequency of the device noise 8002 performed under the conditions B-3 and B-4. FIG. 19A is a diagram 3050 illustrating the result of measurement performed under the condition B-3 and FIG. 19B is a diagram 3060 illustrating the result of measurement performed under the condition B-3.

As illustrated in Figs. 18A and 19A, under the condition B-3, the front-stage average revolution number 8001A was 12576 min⁻¹ and the rear-stage average revolution number was 13354 min⁻¹. This result is the same as those attained under the conditions A-1 and B-1. On the other hand, as illustrated in Figs. 18A and 19B, under the condition B-4, the front-stage average revolution number was 12826 min⁻¹ and the rear-stage average revolution number 8001B was 12809 min⁻¹ That is, these values are smaller than the value of the rear-stage average revolution number 800 1 B measured under the condition B-3.

As illustrated in FIG. 18A and Figs. 19A and 19B, the device noise 8002 under the condition B-3 was 58.7 db(A) and the device noise 8002 under the condition B-4 was 57.7 dB(A). That is, the device noise 8002 measured under the condition B-4 which is the same as that of the fan control device 1 according to this embodiment was lower than that measured under the condition B-3 and was reduced from the value measured under the condition B-3 by about 1 db(A) as in the case in the relation between the conditions B-1 and B-2.

As described above, it has been found that even when the air flow rates of air generated from each front-stage fan and each rear-stage fan are varied, the same result may be obtained by changing the amount of voltages applied in the case that the front-stage fans and the rear-stage fans are disposed in series and in parallel. Incidentally, the values of the device noise illustrated in FIG. 18A are calculated on the basis of the result of analysis of the frequency of the device noise illustrated in FIG. 18C.

As illustrated in FIG. 18B and Figs. 19A and 19B, the total consumption power 8003 of the front-stage and rear-stage fans was 27.80 W under the condition B-3 and was 26.87 W under the condition B-4. That is, the total consumption power 8003 was also the lowest when measured under the condition B-4 which is the same as that of the fan control device 1 according to this embodiment as in the case in the relation between the conditions B-1 and B-2 and was reduced from the value measured under the condition B-3 by about 3%.

As described above, according to the embodiment 2, the air flow rate of air cooling the heating elements 52a and 52b which is determined from the temperatures of the heating elements 52a and 52b, the system impedance within the electronic equipment 50 and the total PQ characteristic of the fans 3a and 3b attained in a state in which the difference in revolution number between the fans 3a and 3b is maintained in the predetermined tolerance is obtained. In addition, the revolution number of each of the fans 3a and 3b is controlled on the basis of the temperatures of the heating elements and the environmental temperature such that the difference in revolution number between the fans 3a and 3b is set in the predetermined tolerance. That is, in the embodiment 2, the revolution number of each of the fans 3a and 3b is controlled on the basis of the heating element temperatures and the environmental temperature such that the needed air flow rate which is needed for cooling the heating elements 52a and 52b and is determined from the temperatures of the heating elements 52a and 52b, the system impedance within the electronic equipment 50 and the total PQ characteristic of the fans 3a and 3b obtained in a state in which the revolution numbers of the fans 3a and 3b are controlled to coincide with each other in the predetermined tolerance may be obtained in a state in which the revolution numbers of the fans 3a a and 3b coincide with each other in the predetermined tolerance.

That is, according to this embodiment, excess noise from driving one fan faster may be avoided by maintaining the difference in revolution number between the fans 3a and 3b in the predetermined tolerance. In addition, in this embodiment, the needed air flow rate may be obtained by taking the temperatures of the heating elements 52a and 52b, the system impedance within the electronic equipment 50 and the total PQ characteristic of the fans 3a and 3b obtained in a state in which the difference in evolution number between the fans 3a and 3b is in the predetermined tolerance into consideration. Therefore, according to this embodiment, the air flow rate suited to cool the heating elements 52a and 52b may be obtained in a state in which the difference in revolution number between the fans 3a and 3b is maintained in the predetermined tolerance regardless of the configuration of the electronic equipment 50 concerned and the locations of the respective fans 3a and 3b within the electronic equipment 50.

As described above, according to this embodiment, the noise generated from the plurality of fans 3a and 3b may be reduced while attaining the air flow rate needed for cooling the heating elements 52A and 52B within the electronic equipment 50 using the plurality of fans 3a and 3b.

In addition, according to this embodiment, the revolution number of the rear-stage fan 3b is reduced more remarkably than that attained when the energy of the same amount is supplied to the both fans 3a and 3b and hence the service life of the rear-stage fan 3b may be increased. Further, according to this embodiment, addition of components is not needed and hence the above mentioned effects may be realized at a cost equivalent to an ever attained cost.

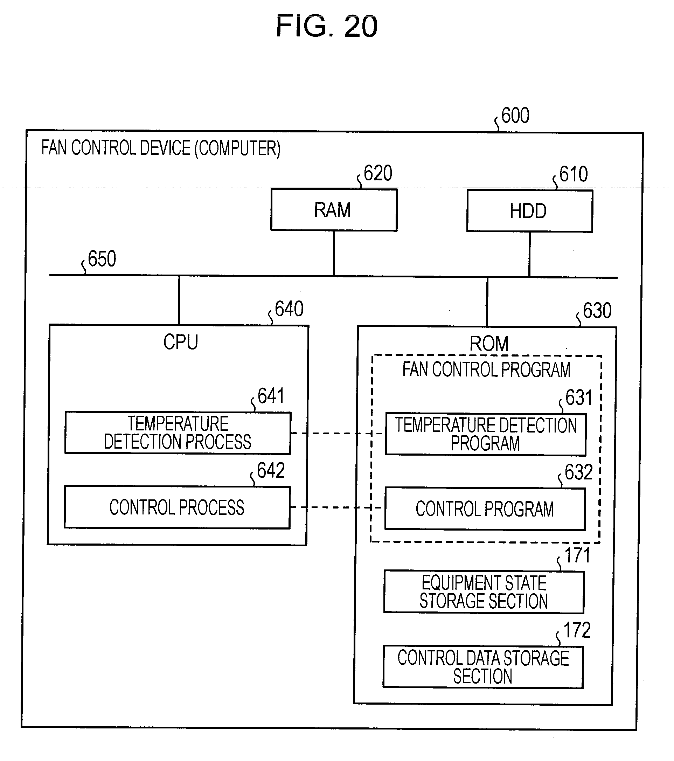

Incidentally, a fan control program is stored in the ROM 17 of the fan control device 1 and functions as mentioned above are implemented by executing this fan control program using the processor 18. Next, an example of a computer for executing the fan control program will be illustrated. FIG. 20 is a functional block diagram illustrating a computer for executing the fan control program.

As illustrated in FIG. 20, a computer 600 serving as the fan control device 1 includes an HDD 610, a RAM 620, a ROM 630, a CPU 60 and a bus 650 for connecting these elements with one another. The ROM 630 corresponds to the ROM 17 illustrated in FIG. 2 and stores in advance the fan control program. The fan control program includes a temperature detection program 631 and a control program 632.

Then, the CPU 640 reads the temperature detection program 631 and the control program 632 out of the ROM 630 and executes these programs. As a result of execution of these programs, the programs 631 and 632 come to function respectively as a temperature detection process 641 and a control process 642. As described above, the CPU 640 corresponds to the processor 18 in FIG. 2.

The ROM 630 includes the equipment state storage section 171 and the control data storage section 172 and stores the equipment state management table 61, the heating-element-temperature-based PWM value determination tables 71a to 71c and the environmental-temperature-based PWM value determination tables 72a to 72c in these storage sections. The CPU 640 reads these tables stored in the ROM 630 and stores these tables in the RAM 620 such that the processes 641 and 642 execute various processes utilizing the data stored in the RAM 620.

### [Embodiment 3]

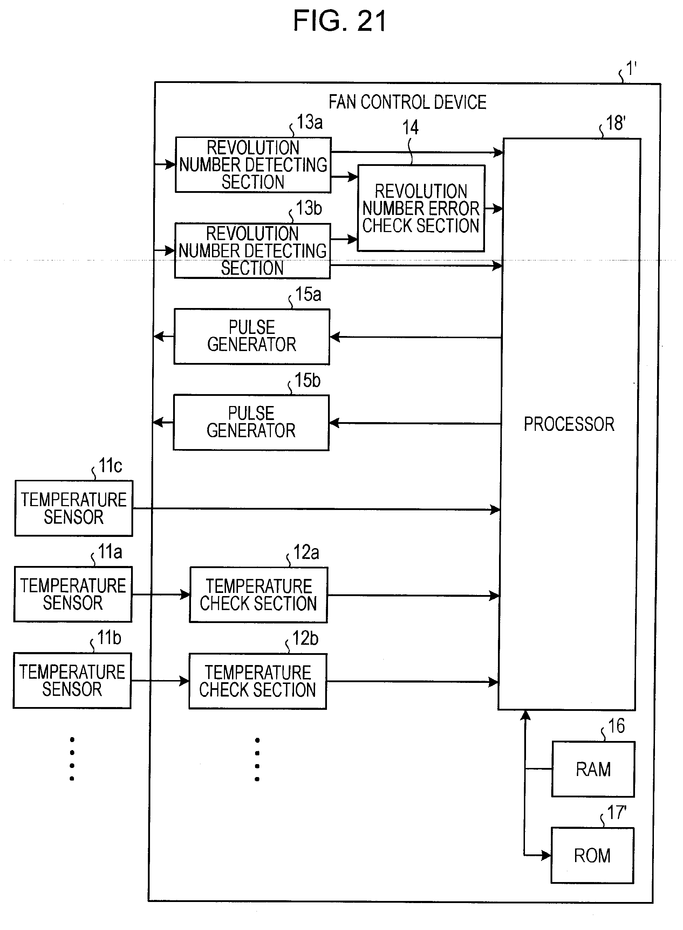

Although, in the above mentioned embodiment 2, the readings detected using the revolution number detecting sections 13a and 13b are used only for revolution number error check, the revolution numbers of the fans 3a and 3b may be utilized as feedback information used to set the difference in revolution number between the fans 3a and 3b in the predetermined tolerance. Next, an embodiment involving a case as mentioned above will be described. FIG. 21 is a block diagram illustrating a configuration of a fan control device according to an embodiment 3. Incidentally, the same numerals are assigned to parts having the same configurations as those previously described and description thereof will be omitted.

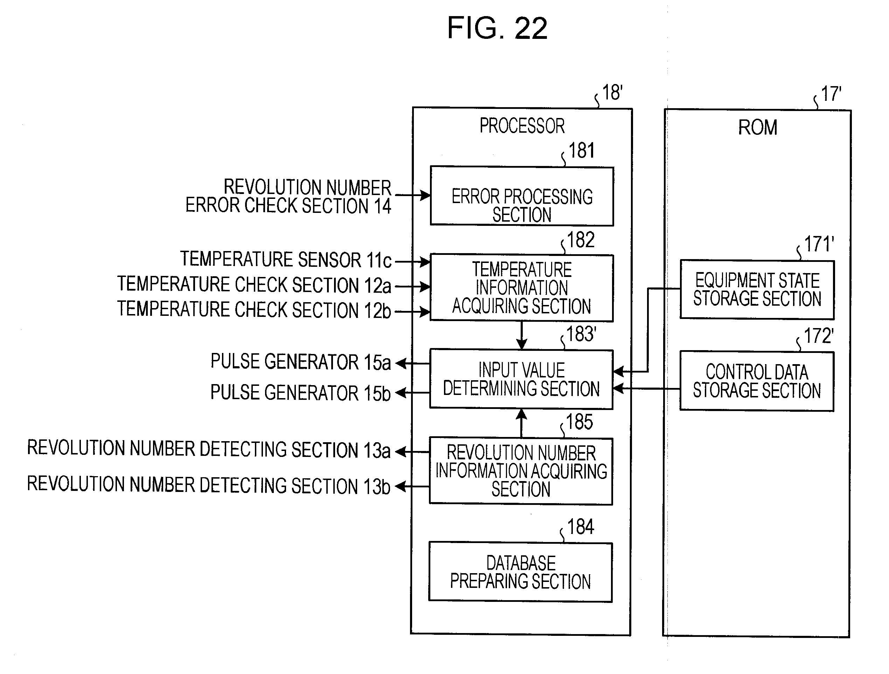

As illustrated in FIG. 21, in a fan control device 1' according to this embodiment, a processor 18' acquires information on the revolution numbers of the fans 3a and 3b from the revolution number detecting sections 13a and 13b. Next, specific configurations of the processor 18' and a ROM 17' according to this embodiment will be described herein below. FIG. 22 is a block diagram illustrating specific configurations of the processor 18' and the ROM 17' according to the embodiment 3.

As illustrated in FIG. 22, the processor 18' according to this embodiment includes the error processing section 181, the temperature information acquiring section 182, an input value determining section 183', the database preparing section 184 and a revolution number information acquiring section 185. The revolution number information acquiring section 185 acquires information on the revolution numbers of the front-stage fan 3a and the rear-stage fan 3b respectively from the revolution number detecting sections 13a and 13b. As described above, the revolution number information acquiring section 185 and the revolution number detecting section 13a function as an example of front-stage revolution number detecting means for detecting the revolution number of the front-stage fan 3a and the revolution number information acquiring section 185 and the revolution number detecting section 13a functions as an example of rear-stage revolution number detecting means for detecting the revolution number of the rear-stage fan 3b.

The input value detecting section 183' then performs feedback control on the revolution number of the rear-stage fan 3b on the basis of information acquired from the revolution number information acquiring section 185. Specifically, in the case that a difference in revolution number between the front-stage fan 3a and the rear-stage fan 3b is out of a predetermined tolerance, the input value determining section 183' changes the revolution number of the rear-stage fan such that the difference in revolution number between the front-stage fan 3a and the rear-stage fan 3b is set in the predetermined tolerance. Processing as mentioned above is executed with reference to a rear-stage PWM value change table stored in a control data storage section 172'.

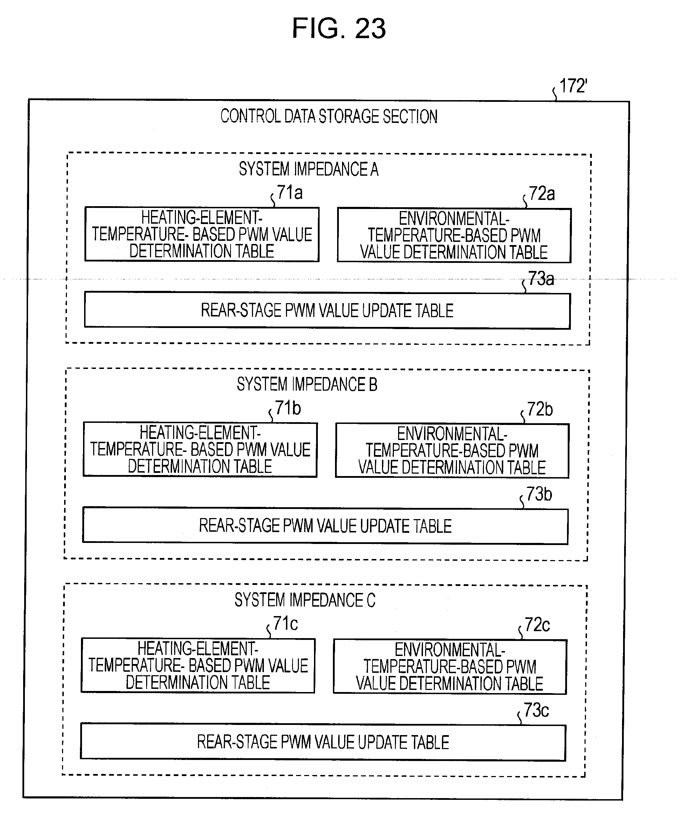

The control data storage section 172' according to this embodiment stores a PWM value for the rear-stage fan 3b obtained when a difference in evolution number between the front-stage fan 3a and the rear-stage fan 3 is reduced to have a value in the predetermined tolerance per revolution number. Next, information stored in the control data storage section 172' will be described. FIG. 23 is a diagram illustrating information stored in the control data storage section according to the embodiment 3.

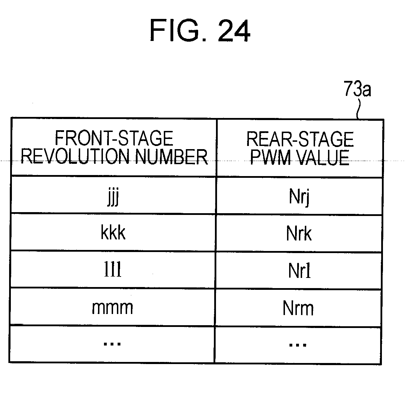

As illustrated in FIG. 23, rear-stage PWM value change tables 73a to 73c corresponding to the system impedances A to C are stored in the control data storage section 172' according to this embodiment in addition to the heating-element-temperature-based PWM value determination tables 71a to 71c and the environmental-temperature-based PWM value determination tables 72a to 72c. FIG. 24 illustrates an example of the rear-stage PWM change table 73a.

As illustrated in FIG. 24, in the rear-stage OWM value change table 73a, each front-stage revolution number indicative of the revolution number of each front-stag fan 3a is stored corresponding to each rear-stage PWM value. For example, in the rear-stage PWM value change table 73a, the front-stage revolution number "jjj" is stored corresponding to the rear-stage PWM value "Nrj".

The rear-stage PWM value stored in the rear-stage PWM value change table 3a is a PWM value needed to control the revolution number of the rear-stage fan 3b to have a difference relative to the evolution number of the front-stage fan 3a in a predetermined tolerance. That is, for example, in the case that the revolution number "kkk" of the front-stage fan 3a has been acquired from the revolution number information acquiring section 185, the input value determining section 183' determines the rear-stage PWM value "Nrk" corresponding to the acquired revolution number with reference to the rear-stage PWM value change table 73 a. The input value determining section 183' then inputs the pulse of the determined rear-stage PWM value "Nrk" into the rear-stage fan 3b via the pulse generator 15b. Owing to the above mentioned operations, even when the revolution number of the front-stage fan 3a differs from the revolution number of the rear-stage fan 3b, the fan control device 1' will be capable of performing correction such that the difference in revolution number between these fans is set in the predetermined tolerance.

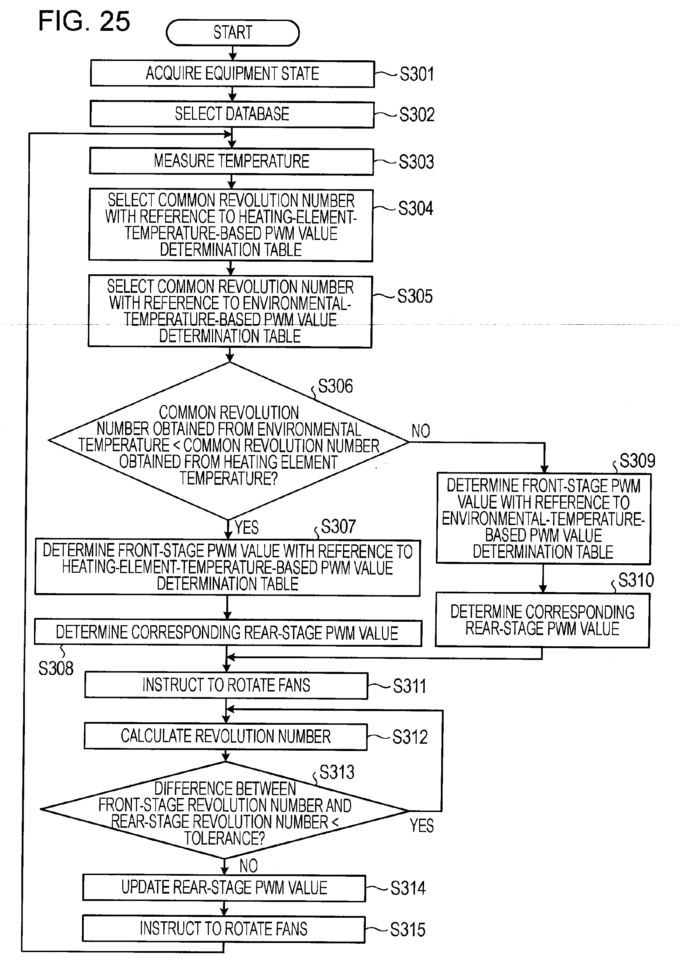

Next, specific operations of the processor 18' according to this embodiment will be described. FIG. 25 is a flowchart illustrating an example of processing executed using the processor 18' according to the embodiment 3. Incidentally, in FIG. 25, in procedures of processing executed using the processor 18', only a procedure of processing involving control of the revolution numbers of the front-stage and rear-stage fans 3a and 3b will be described. Processes executed at steps S301 to S311 in FIG. 25 are the same as the processes executed at steps S201 to S211 in FIG. 11 and hence description thereof will be omitted.

As illustrated in FIG. 25, after an instruction to rotate the fans 3a and 3b has been given at step S311, the input value determining section 183' measures the fan speeds (step S312). Specifically, the input value determining section 183' acquires information on the revolution numbers of the front-stage and rear-stage fans 3a and 3b from the revolution number information acquiring section 185.

Next, the input value determining section 183' judges whether a difference in revolution number between the front-stage and rear-stage fans is in a predetermined tolerance (step S313). In the case that it has been judged that the difference in revolution number between the fans is in the predetermined tolerance in execution of the above mentioned process (Yes at step S313), the input value determining section 183' shifts the process to step S312.

On the other hand, in the case that the difference in revolution number between the fans is not in the predetermined tolerance (No at step S313). The input value determining section 183' changes the rear-stage PWM value (step S314). Specifically, the input value determining section 183' determines, on the basis of information on the revolution number of the front-stage fan 3a acquired from the revolution number acquiring section 185, the rear-state PWM value corresponding to the acquired revolution number of the front-stage fan 3a with reference to the rear-stage PWM value change table. The input value determining section 183' then gives an instruction to rotate the fans (step S315). Specifically, the input value determining section 183' instructs the pulse generator 15b to input the pulse of the rear-stage PWM value which has been determined at step S312 into the rear-stage fan 3b. Owing to the above mentioned operation, the pulse of the rear-stag PWM value conforming to the revolution number of the front-stage fan 3a is input into the rear-stage fan 3b and the revolution numbers of the front-stage fan 3a and the rear-stage fan 3b come into coincidence with each other in the predetermined tolerance.

As described above, in the embodiment 3, in the case that the difference in revolution number between the front-stage fan 3a and the rear-stage fan 3b is out of the predetermined tolerance, the revolution number of the rear-stage fan is changed such that the difference in revolution numbers between the fans is set in the predetermined tolerance. Owing to the above mentioned operation, it may become possible to more set the difference in revolution number between the front- stage fan 3a and the rear-stage fan 3b in the predetermined tolerance.

Although several embodiments haven been described in detail with reference to the accompanying drawings, these embodiments are merely examples and the embodiments may be modified in other forms which are altered and improved in a variety of ways on the basis of skills of persons in the art including the embodying aspects as described above.

For example, although in the above mentioned embodiments, the database preparing section 184 is used only in the case that heating-element-temperature-based PWM value determination tables 71a to 71b and the environmental-temperature-based PWM value determination tables 72a to 72c are prepared, the revolution numbers of the fans 3a and 3b may be controlled using the database preparing section 184.

Specifically, first, the database preparing section 184 acquires the temperatures of the heating elements or the environmental temperature from the temperature information acquiring section 182. Then, the database preparing section 184 calculates a front-stage PWM value and a rear-stage PWM value of pulses to be input into the respective fans 3a and 3b in the case that an air flow rate needed for cooling the heating elements 52a and 52b is obtained in a state in which a difference in revolution number between the fans 3a and 3b is in a predetermined tolerance on the basis of the acquired temperature(s). Then, the database preparing section 184 notifies the input value determining section 183 (or the input value determining section 183') of the calculated front-stage PWM value and rear-stage PWM value.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the scope of the claims.

## Claims

1. A fan controlling apparatus for controlling a plurality of fans arranged to control a temperature of a heat generating object, comprising:
a memory for storing data of the rotational speed of each of the fans in relation to the temperature of the heat generating object; and
a controller for controlling the rotational speed of each of the fans respectively in dependence on the temperature of the heat generating object in reference to the data stored in the memory.

2. The fan controlling apparatus according to claim 1, wherein
the controller controls the rotational speed of each of the fans so that the difference between actual rotational speeds of each of the fans is within a predetermined value.

3. The fan controlling apparatus according to claim 1 or 2, wherein
the data that the memory stores are control parameters of each of the fans with respect to a plurality of the temperatures.

4. The fan controlling apparatus according to claim 3, wherein
the control parameters are respectively values of pulse width in accordance with the pulse width control of each fan, and
the parameters are respectively parameters corresponding to pulse width inputs to each of the fans.

5. The fan controlling apparatus according to any preceding claim, wherein
the controller controls the rotational speeds of each of the fans to be within 10 percent of each other.

6. A fan controlling method for controlling a plurality of fans which are arranged to control a temperature of a heat generating object, comprising:
detecting the temperature of a hot generating object; and
controlling the rotational speed of each of the fans respectively in dependence on the temperature detected in reference to data stored in the memory, the memory storing the data of the rotational speed each of fans in relation to the temperature of the heat generating object.

7. The fan controlling method according to claim 6, wherein
the controlling controls the rotational speed of each of the fans so that the difference between actual rotational speeds of each of the fans is within a predetermined value.

8. The fan controlling method according to claim 6, wherein
the data that the memory stored are control parameters of each of the fans with respect to a plurality of the temperatures.

9. The fan controlling method according to claim 8, wherein
the control parameters are respectively values of pulse width in accordance with the pulse width control of each fan, and
the parameters are respectively parameters corresponding to pulse width inputs to each of the fans.

10. The fan controlling method according to claim 6, wherein
the controlling controls the rotational speeds of each of the fans to be within 10 percent of each other.

11. An apparatus or method according to any of claims 1 to 10 wherein the fans are arranged in series within a ventilation chamber in an electronic apparatus which contains the heat generating object.

12. A computer program for controlling a plurality of fans arranged to control a temperature of a heat generating object, the program being designed to make a computer perform the steps of:
detecting the temperature of the heat generating object; and
controlling the rotational speed of each of the fans respectively in dependence on the temperature detected in reference to data stored in the memory, the memory storing the data of the rotational speed each of fans in relation to the temperature of the heat generating object.

13. A computer-readable medium on which is stored the program according to claim 12.
